# EUROPEAN PATENT APPLICATION

(11) **EP 4 848 932 A1**
(43) Date of publication of application: **02.12.2026**
(21) Application number: 25179429.3
(22) Date of filing: 28.05.2025
(51) Int. Cl.: H10D 30/47, H10D 30/01, H10D 62/10, H10D 62/17, H10D 64/20, H10D 62/85

(54) **III-NITRIDE BASED BI-DIRECTIONAL DEVICE AND METHOD OF FORMING THE SAME**

(71) Applicant: Infineon Technologies Austria AG, 9500 Villach (AT)
(72) Inventor: MINETTO, Andrea, Los Angeles, 90025 (US); IMAM, Mohamed, Tempe, USA, 85284 (US); KIM, Hyeongnam, Chandler, USA, 85248 (US); LESSA GOMES, Joao Lucas, 1180 Wien (AT)
(74) Representative: Infineon Patent Department

(57) **Abstract**

A III-nitride based bi-directional device comprises: a III-nitride heterostructure (104) configured to provide a channel of a first conductivity type; first and second conduction electrodes (106, 108) formed on the III-nitride heterostructure and operatively coupled to the channel; and first and second enhancement mode gate structures (110, 112) disposed laterally between the first and the second conduction electrodes and disposed over respective first and second gate regions of the III-nitride heterostructure, wherein the first and the second enhancement mode gate structures comprise respective first and second gate electrodes. The III-nitride based bi-directional device further comprises: a first III-nitride access region layer (202) of a second conductivity type, wherein the first III-nitride access region layer is operatively coupled to the first gate structure, and wherein the first III-nitride access region layer is disposed over a first portion of an access region of the III-nitride heterostructure formed laterally between the first and the second gate regions, the first portion of the access region extending from an edge of the first gate region in a direction towards the second gate region; and a second III-nitride access region layer (204) of the second conductivity type, wherein the second III-nitride access region layer is operatively coupled to the second gate structure, and wherein the second III-nitride access region layer is disposed over a second portion of the access region, the second portion of the access region extending from an edge of the second gate region in a direction towards the first gate region.

## Description

### TECHNICAL FIELD

The present disclosure relates generally to semiconductor devices, and more particularly to III-nitride based semiconductor devices, such as III-nitride based bi-directional devices.

### BACKGROUND

III-nitride based transistors such as gallium nitride (GaN) based high electron mobility transistors (HEMTs) exhibit advantageous electrical properties that make them particularly suitable for medium to high-voltage applications, among others.

In such applications, bi-directional switching functionality is often desirable. However, GaN based HEMTs typically exhibit significant reverse leakage currents when a negative voltage is applied across their source and drain. Accordingly, typical GaN based HEMTs provide for unidirectional switching capabilities only.

### SUMMARY

According to a first aspect of the present disclosure, there is provided a III-nitride based bi-directional device. The III-nitride based bi-directional device comprises: a III-nitride heterostructure configured to provide a channel of a first conductivity type; first and second conduction electrodes formed on the III-nitride heterostructure and operatively coupled to the channel; first and second enhancement mode gate structures disposed laterally between the first and the second conduction electrodes and disposed over respective first and second gate regions of the III-nitride heterostructure, wherein the first and the second enhancement mode gate structures comprise respective first and second gate electrodes; a first III-nitride access region layer of a second conductivity type, wherein the first III-nitride access region layer is operatively coupled to the first gate structure, and wherein the first III-nitride access region layer is disposed over a first portion of an access region of the Ill-nitride heterostructure formed laterally between the first and the second gate regions, the first portion of the access region extending from an edge of the first gate region in a direction towards the second gate region; and a second III-nitride access region layer of the second conductivity type, wherein the second III-nitride access region layer is operatively coupled to the second gate structure, and wherein the second III-nitride access region layer is disposed over a second portion of the access region, the second portion of the access region extending from an edge of the second gate region in a direction towards the first gate region.

According to a second aspect of the present disclosure, there is provided a method of forming a III-nitride based bi-directional device. The method comprises: providing a III-nitride heterostructure comprising a heterojunction configured to provide a channel of a first conductivity type; forming first and second conduction electrodes on respective first and second electrode regions of the III-nitride heterostructure, the first and the second conduction electrodes being operatively coupled to the channel; forming first and second enhancement mode gate structures over respective first and second gate regions of the III-nitride heterostructure, the first and the second enhancement mode gate structures comprising respective first and second gate electrodes, the first and the second gate regions being positioned laterally between the first and the second electrode regions; and forming first and second III-nitride access region layers over respective first and second portions of an access region of the III-nitride heterostructure formed laterally between the first and the second gate regions; wherein the first portion of the access region extends from an edge of the first gate region in a direction towards the second gate region; wherein the second portion of the access region extends from an edge of the second gate region in a direction towards the first gate region; and wherein the first and the second III-nitride access region layers are of a second conductivity type and are operatively coupled to the respective first and the second gate structures.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1 schematically illustrates a cross-sectional view of an example III-nitride based bi-directional device;
Fig. 2 schematically illustrates a cross-sectional view of an example III-nitride based bi-directional device comprising first and second access region layers;
Fig. 3 schematically illustrates another cross-sectional view of the example III-nitride based bi-directional device shown in Fig. 2;
Fig. 4 schematically illustrates a cross-sectional view of a III-nitride based bi-directional device when in use;
Fig. 5 depicts a graph illustrating simulated electric field distributions in channels of different III-nitride based bi-directional devices;
Figs. 6-13 schematically illustrate cross-sectional views of respective portions of various example III-nitride based bi-directional devices;
Fig. 14 schematically illustrates a cross-sectional view of a III-nitride based enhancement mode transistor comprising a III-nitride access region layer;
Fig. 15 depicts a flow chart illustrating a method of forming a III-nitride based bi-directional device;
Fig. 16 depicts a flow chart illustrating a method for forming first and second III-nitride access region layers of a III-nitride based bi-directional device;
Fig. 17 depicts a flow chart illustrating another method for forming first and second III-nitride access region layers of a III-nitride based bi-directional device;
Fig. 18 depicts a flow chart illustrating another method for forming first and second III-nitride access region layers of a III-nitride based bi-directional device;
Figs. 19a-19d schematically illustrate cross-sectional views of starting and intermediate structures obtained during performance of the method illustrated by the flow chart shown in Fig. 18;
Fig. 20 depicts a flow chart illustrating another method for forming first and second III-nitride access region layers of a III-nitride based bi-directional device;
Fig. 21a-21c schematically illustrate cross-sectional views of intermediate structures obtained during performance of the method illustrated by the flow chart shown in Fig. 20; and
Fig. 22 schematically illustrates a semiconductor package comprising a III-nitride based bi-directional device.

### DETAILED DESCRIPTION

The examples described herein provide enhancement mode III-nitride based devices, such as enhancement mode III-nitride based bi-directional devices. Various devices of the present disclosure comprise III-nitride access region layer(s) configured to reduce peak electric field intensities experienced in the channels of these devices during use. Accordingly, the provision of such III-nitride access region layer(s) may enable III-nitride based enhancement mode devices having an improved reliability and/or an extended lifetime relative to known devices.

Each of the III-nitride based devices of the present disclosure may be suitable for medium and/or high-voltage applications. Devices suitable for medium-voltage applications may be operable to withstand, for example, voltage differences across their conduction or source/drain electrodes of (e.g. about) 120 V or less, such as voltage differences in the range from (e.g. about) 40 V to (e.g. about) 120 V inclusive. Such voltage differences may be referred to as "medium voltages" or "medium voltage differences". Devices suitable for high-voltage applications may be operable to withstand, for example, voltage differences across their conduction or source/drain electrodes of greater than (e.g. about) 120 V, such as (e.g. about) 300 V or higher, (e.g. about) 650 V or higher, or (e.g. about) 1200 V or higher. Such voltage differences may be referred to as "high voltages" or "high voltage differences".

As used herein, the phrase "III-nitride" may refer to a compound semiconductor that includes nitrogen (N) and at least one group III element, including aluminium (Al), gallium (Ga), indium (In), and boron (B), and including but not limited to any of its alloys, such as aluminium gallium nitride (AlxGa(1-x)N), indium gallium nitride (InyGa(1-y)N), aluminium indium gallium nitride (AlxlnyGa(1-x-y)N), gallium arsenide phosphide nitride (GaAsaPbN(1-a-b)), and aluminium indium gallium arsenide phosphide nitride (AlxlnyGa(1-x-y)AsaPbN(1-a-b)), for example. III-nitride may also refer generally to any polarity including but not limited to Ga-polar, N-polar, semi-polar or non-polar crystal orientations. A III-nitride material may also include either the Wurtzitic, Zincblende, or mixed polytypes, and may include single-crystal, monocrystalline, polycrystalline, or amorphous structures.

While the following describes various example III-nitride based devices comprising respective III-nitride heterostructures configured to provide n-type channels, it is to be understood that these examples are merely for illustrative purposes and that the present disclosure is not so limited. More generally, each of the III-nitride based devices of the present disclosure may comprise a III-nitride heterostructure configured to provide a channel of a first conductivity type, which may be n-type or p-type. As used herein, the term "conductivity type" may refer to a type of majority charge carriers in the region, material, layer, body etc. referred to, where n-type refers to majority charge carriers consisting of electrons, and p-type refers to majority charge carriers consisting of holes.

While it is described in the following that various example III-nitride heterostructures may be configured to provide a channel operable to support a two-dimensional electron gas (2DEG), it is to be understood that these examples are merely for illustrative purposes and that the present disclosure is not so limited. More generally, each of the III-nitride heterostructures of the present disclosure may be configured to provide a channel operable to support a two-dimensional carrier gas, which may be a 2DEG or a two-dimensional hole gas (2DHG), depending on a conductivity type of the channel. For example, the two-dimensional carrier gas may be a 2DEG when the channel is n-type and may be a 2DHG when the channel is p-type.

While it is described in the following that each of the various enhancement mode gate structures may employ a p-doped III-nitride layer to provide for enhancement mode functionality, it is to be understood that the present disclosure is not so limited and that any other enhancement mode technology may be alternatively employed.

While the following description refers to various example III-nitride access region layers as being p-type or p-doped, it is to be understood that this is merely for illustrative purposes and that the present disclosure is not so limited. More generally, each of the III-nitride access region layers of the present disclosure may be of a second conductivity type, which may be the complement of the first conductivity type. Thus, in examples where the first conductivity type is n-type, the second conductivity type may be p-type, and vice versa.

Where any exemplary explanation given in the following invokes any particular conductivity type(s) of any particular region(s), material(s), layer(s), bodies etc., it is to be understood that the explanation is equally valid for complementary conductivity types.

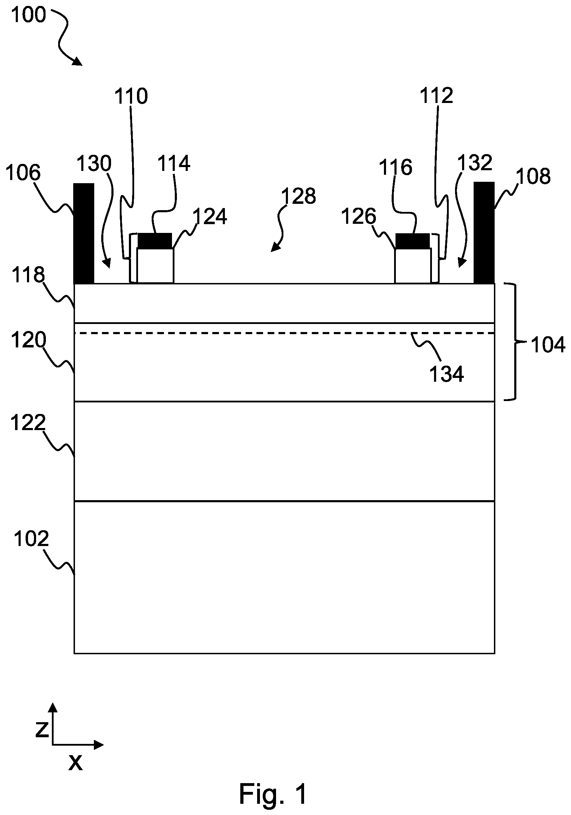

**Fig. 1** schematically illustrates a cross-sectional view of an example III-nitride based bi-directional device 100. The III-nitride based bi-directional device 100 comprises: a substrate 102; a III-nitride heterostructure 104 disposed over the substrate 102; first and second conduction electrodes 106, 108 formed on the III-nitride heterostructure 104; and first and second enhancement mode gate structures 110, 112 disposed laterally between the first and the second conduction electrodes 106, 108 and disposed over respective first and second gate regions of the III-nitride heterostructure 104. The first and the second enhancement mode gate structures 110, 112 comprise first and second gate electrodes 114, 116, respectively.

As will be discussed further below, when the III-nitride based bi-directional device 100 is in use, the first and the second gate electrodes 114, 116 of the first and the second gate structures 110, 112 may be biased to selectively permit or (e.g. substantially) block a flow of current between the first and the second conduction electrodes 106, 108 in either direction (i.e. from the first conduction electrode 106 to the second conduction electrode 108, or vice versa).

The substrate 102 may comprise any suitable substrate material. For example, the substrate 102 may comprise or consist of any one of: gallium nitride (GaN); silicon (Si); silicon carbide (SiC); diamond; sapphire; aluminium nitride (AIN); or any other suitable substrate material.

The III-nitride heterostructure 104 may be configured to provide an n-type channel. The III-nitride heterostructure 104 may comprise a III-nitride barrier layer 118 and a III-nitride channel layer 120. The III-nitride barrier layer 118 and the III-nitride channel layer 120 may be compositionally different from each other such that a bandgap of the Ill-nitride barrier layer 118 is greater than a bandgap of the III-nitride channel layer 120. It may be that, for example, the III-nitride barrier layer 118 comprises or consists of AlGaN (of any suitable molar composition) and the III-nitride channel layer 120 comprises or consists of GaN. The III-nitride barrier layer 118 may be disposed over the III-nitride channel layer 120. For example, the III-nitride barrier layer 118 may be formed directly on the III-nitride channel layer 120. Alternatively, there may be one or more III-nitride interlayers (not shown) disposed between the III-nitride barrier layer 118 and the III-nitride channel layer 120. The one or more III-nitride interlayers may comprise, for example, an AIN layer configured to mitigate against alloy scattering of electrons in the channel.

The channel may comprise a potential well formed laterally in the III-nitride heterostructure 104. For example, the potential well may be formed laterally in the III-nitride channel layer 120 at or adjacent a heterointerface between the III-nitride channel layer 120 and another layer of the III-nitride heterostructure 104, such as the III-nitride barrier layer 118 or one of the one or more interlayers (when present). The potential well may be suitable for supporting a two-dimensional electron gas (2DEG), which is schematically illustrated by the dashed line 134 in Fig. 1. The composition of the III-nitride barrier layer 118 and the III-nitride channel layer 120 may give rise to spontaneous and/or piezoelectric polarization that may support the formation of the 2DEG in the channel.

It is to be understood that while the dashed line 134 is shown in Fig. 1 to be laterally continuous across the III-nitride based bi-directional device 100, this is merely for ease of illustration. As will be discussed further below, the 2DEG 134 may be depleted in one or more portions of the channel, such as under one or both of the first and the second gate structures 110, 112, depending on an operating state of the III-nitride based bi-directional device 100. In such cases, the 2DEG 134 may be laterally discontinuous across the III-nitride based bi-directional device 100.

The III-nitride based bi-directional device 100 may additionally comprise a buffer layer 122. The buffer layer 122 may be disposed between the substrate 102 and the III-nitride heterostructure 104. The buffer layer 122 may be configured to accommodate a lattice mismatch (if present) between respective mating surfaces of the III-nitride heterostructure 104 and the substrate 102. The composition of the buffer layer 122 may depend on the composition of the substrate 102 and the III-nitride heterostructure 104. The buffer layer 122 may comprise or consist of any suitable III-nitride compound or compounds.

The first and the second conduction electrodes 106, 108 may be formed on the (e.g. III-nitride barrier layer 118 of the) III-nitride heterostructure 104 in respective first and second electrode regions. The first and the second conduction electrodes 106, 108 may comprise or consist of any suitable material, such as any suitable metal, metal alloy, or combination thereof. The first and the second electrode regions are laterally spaced apart in a first direction (e.g. the x direction depicted in Fig. 1). The first and the second conduction electrodes 106, 108 may be electrically coupled to the channel and therefore the 2DEG 134. For example, the first and the second conduction electrodes 106, 108 may form ohmic or Schottky contacts to the 2DEG 134.

The first and the second gate structures 110, 112 are enhancement mode gate structures. That is, the first gate structure 110 is configured to have a positive threshold voltage such that at least a portion of the channel underlying the first gate structure 110 is (e.g. substantially) fully depleted of electrons when the first gate structure 110 is biased at 0 volts (V). Similarly, the second gate structure 112 is configured to have a positive threshold voltage such that at least a portion of the channel underlying the second gate structure 112 is (e.g. substantially) fully depleted of electrons when the second gate structure 112 is biased at 0V.

Biasing the first gate structure 110 may refer to applying a voltage to the first gate electrode 114 of the first gate structure 110 with respect to the first conduction electrode 106. Accordingly, biasing the first gate structure 110 at 0V may refer to biasing the first gate electrode 114 of the first gate structure 110 at the same voltage as the first conduction electrode 106.

Similarly, biasing the second gate structure 112 may refer to applying a voltage to the second gate electrode 116 of the second gate structure 112 with respect to the second conduction electrode 108.

The first gate structure 110 may comprise a first III-nitride (e.g. GaN) layer 124 disposed between the (e.g. III-nitride barrier layer 118 of the) III-nitride heterostructure 104 and the first gate electrode 114. The first III-nitride layer 124 is a p-type layer which may be p-doped by way of any suitable acceptor, including but not limited to magnesium. The first III-nitride layer 124 may be electrically coupled to the first gate electrode 114. For example, the first gate electrode 114 may form an ohmic or a Schottky contact with the first IlI-nitride layer 124.

The provision of the first III-nitride layer 124 may enable the enhancement mode functionality of the first gate structure 110 described above. This can be understood as follows.

The first III-nitride layer 124 may form a first diode-like structure with a portion of the n-type channel underlying the first gate structure 110. When the first gate structure 112 is biased at 0V, the first diode-like structure may be biased so as to cause electrons in at least a portion of the channel underlying the first III-nitride layer 124 to be (e.g. substantially) fully depleted. This depletion of electrons in the channel at a gate bias of 0V may therefore give rise to a positive threshold voltage for the first gate structure 110.

The second gate structure 112 may comprise a second III-nitride (e.g. GaN) layer 126 disposed between the (e.g. III-nitride barrier layer 118 of the) III-nitride heterostructure 104 and the second gate electrode 116. The second III-nitride layer 126 is a p-type layer which may be p-doped by way of any suitable acceptor, including but not limited to magnesium. The second Ill-nitride layer 126 may be electrically coupled to the second gate electrode 116. For example, the second gate electrode 116 may form an ohmic or a Schottky contact with the second III-nitride layer 126. The provision of the second Ill-nitride layer 126 may enable the enhancement mode functionality of the second gate structure 112 discussed above for similar reasons to those discussed in relation to the first III-nitride layer 124 of the first gate structure 110.

Each of the first and the second III-nitride layers 124, 126 may have any suitable doping concentration and any suitable thickness. As an illustrative example, it may be that a (e.g. average) acceptor doping concentration of the first and the second III-nitride layers 124, 126 is in the range of (e.g. about) 1x10¹⁹ cm⁻³ to (e.g. about) 5x10¹⁹ cm⁻³ inclusive. Additionally or alternatively, it may be that a thickness of each of the first and the second III-nitride layers 124, 126 (or at least respective portions thereof disposed directly between the III-nitride heterostructure 104 and respective ones of the first and the second gate electrodes 114,116) is in the range of (e.g. about) 200 nm to (e.g. about) 400 nm inclusive. However, it will be appreciated that the present disclosure is not so limited and that other doping concentrations and/or thicknesses may be employed.

The first and the second gate electrodes 114, 116 may comprise or consist of any suitable material, such as any suitable metal, metal alloy, or combination thereof. For example, in examples wherein the first and the second gate electrodes 114, 116 form respective ohmic contacts to the first and the second III-nitride layers 124, 126, the first and the second gate electrodes 114, 116 may comprise or consist of titanium (Ti).

As another example, in examples wherein the first and the second gate electrodes 114, 116 form respective Schottky contacts to the first and the second III-nitride layers 124, 126, the first and the second gate electrodes 114, 116 may comprise or consist of titanium nitride (TiN).

The III-nitride based bi-directional device 100 may comprise a first access region 128 formed laterally between the first gate region and the second gate region. The first access region 128 may be a drift region of the III-nitride based bi-directional device 100. For example, the first access region 128 may be configured to withstand (e.g. up to a maximum rated voltage difference) a voltage difference of either polarity applied between the first and the second conduction electrodes 106, 108 when the III-nitride based bi-directional device 100 is operated in a blocking operating state.

The III-nitride based bi-directional device 100 may additionally comprise a second access region 130 formed laterally between the first electrode region and the first gate region, and a third access region 132 formed laterally between the second gate region and the second electrode region.

When the III-nitride based bi-directional device 100 is in use, a voltage difference may be applied between the first conduction electrode 106 and the second conduction electrode 108 such that either: a voltage of the second conduction electrode 108 is greater (i.e. more positive) than a voltage of the first conduction electrode 106 (where such a voltage difference may be referred to as a positive voltage difference); or a voltage of the second conduction electrode 108 is less (i.e. more negative) than a voltage of the first conduction electrode 106 (where such a voltage difference may be referred to as a negative voltage difference).

When a positive voltage difference is applied between the first and the second conduction electrodes 106, 108, the first conduction electrode 106 may be referred to as a low-voltage electrode and the second conduction electrode 108 may be referred to as a high-voltage electrode. This may be to indicate that, with respect to a common reference, the voltage applied to the first conduction electrode 106 may be relatively lower than the voltage applied to the second conduction electrode 108.

When a positive voltage difference is applied between the first and the second conduction electrodes 106, 108, the first gate structure 110 may be referred to as a low-voltage gate structure and the second gate structure 112 may be referred to as a high-voltage gate structure. This may be to indicate that, with respect to a common reference, a voltage applied to the first gate electrode 114 of the first gate structure 110, which is biased relative to the first conduction electrode 106 (i.e. the low-voltage electrode), may be relatively lower than a voltage applied to the second gate electrode 116 of the second gate structure 112, which is biased relative to the second conduction electrode 108 (i.e. the high-voltage electrode).

When a negative voltage difference is applied between the first and the second conduction electrodes 106, 108, the naming conventions described above may be reversed. That is, the first conduction electrode 106 may be referred to as the high-voltage electrode, the second conduction electrode 108 may be referred to as the low-voltage electrode, the first gate structure 110 may be referred to as the high-voltage gate structure, and the second gate structure 112 may be referred to as the low-voltage gate structure.

It is to be understood that in the above examples the terms "low-voltage" and "high-voltage" are not intended to refer to any particular voltage values.

When in use, the III-nitride based bi-directional device 100 may be operable in a plurality of different operating states. The operating state implemented may depend on whether the III-nitride based bi-directional device 100 is to operate in a conducting state (i.e.to permit a flow of current between the first and the second conduction electrodes 106, 108) or a blocking state (i.e. to (e.g. substantially) block a flow of current between the first and the second conduction electrodes 106, 108). Additionally, the operating state implemented may depend on whether a positive or a negative voltage difference is applied between the first and the second conduction electrodes 106,108.

In a first conducting operating state, the III-nitride based bi-directional device 100 may be operable to permit a flow of current between the first and the second conduction electrodes 106, 108 in either direction. The direction of current flow may depend on, for example, whether the voltage difference applied between the first and the second conduction electrodes 106,108 is positive or negative. In the first conducting operating state, each of the first gate structure 110 and the second gate structure 112 may be biased in respective on-states.

Biasing a gate structure (such as the first gate structure 110 or the second gate structure 112) in an on-state may refer to biasing a gate electrode of the gate structure (such as the first gate electrode 114 or the second gate electrode 116) above its threshold voltage. Similarly, biasing a gate structure in an off-state may refer to biasing the gate electrode of the gate structure below its threshold voltage.

In a first blocking operating state, the III-nitride based bi-directional device 100 may be operable to (e.g. substantially) block a current flow between the first and the second conduction electrodes 106, 108 in the presence of a positive voltage difference applied between the first and the second conduction electrodes 106, 108 (e.g. but not in the presence of negative such voltage differences). In this operating state, the first gate structure 110 may be biased in its off-state, and the second gate structure 112 may be biased in its on-state.

In a second blocking operating state, the III-nitride based bi-directional device 100 may be operable to (e.g. substantially) block a current flow between the first and the second conduction electrodes 106, 108 in the presence of a negative voltage difference applied between the first and the second conduction electrodes 106, 108 (e.g. but not in the presence of positive such voltage differences). In this operating state, the second gate structure 112 may be biased in its off-state, and the first gate structure 110 may be biased in its on-state.

In a third blocking operating state, the III-nitride based bi-directional device 100 may be operable to (e.g. substantially) block a current flow between the first and the second conduction electrodes 106, 108 in the presence of positive or negative voltage differences applied between the first and the second conduction electrodes 106, 108. In this operating state, each of the first and the second gate structures 110, 112 may be biased in respective off states.

When the III-nitride based bi-directional device 100 is operated in a blocking operating state, such as one of the first to third blocking operating states described above, a voltage difference applied between the first and the second conduction electrodes 106, 108 may be (e.g. substantially) accommodated (e.g. dropped across) the first access region 128 of the III-nitride bi-directional device 100. Accordingly, operating the device 100 in a blocking operating state in the presence of a voltage difference applied between the first and the second conduction electrodes 106, 108 may give rise to an electric field in the first access region 128 (which may be referred to as a blocking electric field). Such an electric field typically has a peak intensity adjacent the low-voltage gate structure of the III-nitride based bi-directional device 100.

Repeated exposure to this peak electric field intensity can induce damage in the III-nitride based bi-directional device 100 near the low-voltage gate structure. Such damage may degrade the electrical performance of the III-nitride based bi-directional device 100 and may give rise to reliability issues which may ultimately impinge on the usable lifetime of the III-nitride based bi-directional device 100.

Accordingly, there remains a desire for a III-nitride based bi-directional device operable to address or at least ameliorate one or more of the above-discussed issues.

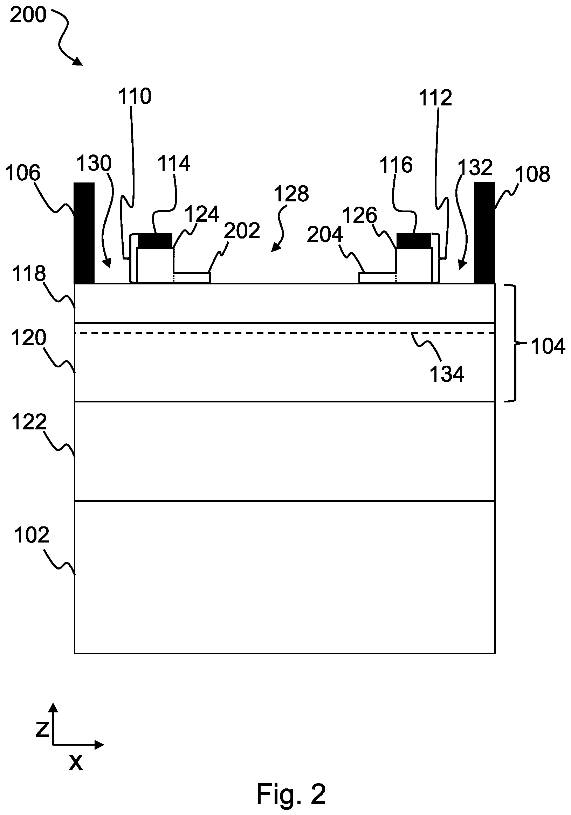

**Fig. 2** schematically illustrates a cross-sectional view of an example III-nitride based bi-directional device 200 (which may alternatively be referred to as a bi-directional switch). The III-nitride based bi-directional device 200 has a number of elements in common with the III-nitride based bi-directional device 100 shown in Fig. 1. Such common elements may be denoted by common reference numerals in Figs. 1 and 2 and will not be described again in detail here, for the sake of brevity and clarity. It is to be understood that, unless incompatible, any one or more of the features or elements discussed herein in relation to III-nitride based bi-directional device 100 may be combined in any combination with any one or more of the features or elements discussed in the following in relation to the III-nitride based bi-directional device 200.

The III-nitride based bi-directional device 200 comprises a first III-nitride access region layer 202 and a second III-nitride access region layer 204.

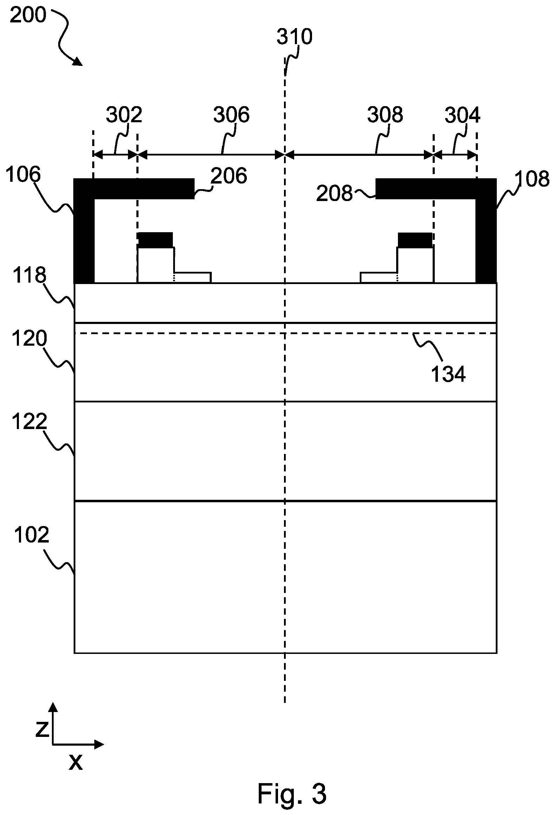

The III-nitride based bi-directional device 200 may additionally comprise a first field plate 206 and a second field plate 208 (depicted in Fig. 3 only for ease of illustration). When present, the first field plate 206 may be electrically coupled to the first conduction electrode 106 and the second field plate 208 may be electrically coupled to the second conduction electrode 108. The first field plate 206 may extend from the first conduction electrode 106 over at least a portion of the first III-nitride access region layer 202. For example, the first field plate 206 may extend, along the first direction (e.g. the x-direction shown in Fig. 2), from the first conduction electrode 106 over an entirety of the first III-nitride access region layer 202. As another example, the first field plate 206 may extend, along the first direction, from the first conduction electrode 106 beyond an end of the first III-nitride access region layer 202. The second field plate 208 may extend from the second conduction electrode 108 over at least a portion of the second III-nitride access region layer 204. For example, the second field plate 208 may extend, along the first direction, from the second conduction electrode 108 over an entirety of the second III-nitride access region layer 204. As another example, the second field plate 208 may extend, along the first direction, from the second conduction electrode 108 beyond an end of the second III-nitride access region layer 204.

Each of the first and the second III-nitride access region layers 202, 204 may comprise or consist of any suitable III-nitride compound, including but not limited to GaN, AlGaN (of any suitable molar composition), indium gallium nitride (InGaN) (of any suitable molar composition), and indium aluminium nitride (InAIN) (of any suitable molar composition).

Each of the first and the second III-nitride access region layers 202, 204 are p-type layers, which may be p-doped by way of any suitable acceptor, including but not limited to magnesium.

Each of the first and the second III-nitride access region layers 202, 204 may have any suitable doping concentration and any suitable thickness. As an illustrative example, it may be that a (e.g. average) acceptor doping concentration of the first and the second III-nitride access region layers 202, 204 is in the range of (e.g. about) 1x10¹⁶ cm⁻³ to (e.g. about) 1x10¹⁹ cm⁻³ inclusive. Additionally or alternatively, it may be that a (e.g. average) thickness of each of the first and the second III-nitride access region layers 202, 204 (e.g. throughout their length) is in the range of (e.g. about) 10 nm to (e.g. about) 100 nm inclusive. However, it will be appreciated that the present disclosure is not so limited and that other doping concentrations and/or thicknesses may be employed.

The first III-nitride access region layer 202 may be disposed over a first portion of the first access region 128 of the III-nitride heterostructure 104. The first portion of the first access region 128 may extend from (e.g. directly) adjacent an edge of the first gate region in a direction towards the second gate region. While not depicted in Fig. 2, the first III-nitride access region layer 202 may additionally be disposed over a first portion of the second access region 130. The first portion of the second access region 130 may extend from (e.g. directly) adjacent an edge of the first gate region in a direction towards the first electrode region. The first III-nitride access region layer 202 may be operatively coupled to the III-nitride heterostructure 104 in the first portion of the first access region 128 (and in the first portion of the second access region 130, where applicable). As used herein, the term "operatively coupled" may encompass, for example, a direct (e.g. physical) coupling or an indirect (e.g. physical) coupling by way of one or more intermediate layers, such as one or more semiconductor (e.g. III-nitride) layers.

The first III-nitride access region layer 202 may be operatively coupled to at least a portion of the first gate structure 110. For example, the first III-nitride access region layer 202 may be (e.g. laterally) operatively coupled to at least a portion of the first III-nitride layer 124. For example, the first III-nitride access region layer 202 may be contiguous (e.g. and distinct from) or continuous with at least a portion of the first III-nitride layer 124. Additionally or alternatively, while not depicted in Fig. 2, the first III-nitride access region layer 202 may be in physical contact with the first gate electrode 114. For example, the first gate electrode 114 may be disposed over and directly on at least a portion of an upper surface of the first III-nitride access region layer 202. Alternatively, it may be that the first gate electrode 114 does not directly contact any part of the upper surface of the first III-nitride access region layer 202.

Accordingly, the first III-nitride access region layer 202 may be at least indirectly biased by the first gate electrode 114 by way of its operative coupling to the first gate structure 110.

The second III-nitride access region layer 204 may be disposed over a second portion of the first access region 128 of the III-nitride heterostructure 104. The second portion of the first access region 128 may extend from (e.g. directly) adjacent an edge of the second gate region in a direction towards the first gate region. While not depicted in Fig. 2, the second III-nitride access region layer 204 may additionally be disposed over a first portion of the third access region 132. The first portion of the third access region 132 may extend from (e.g. directly) adjacent an edge of the second gate region in a direction towards the second electrode region. The second III-nitride access region layer 204 may be operatively coupled to the III-nitride heterostructure 104 in the second portion of the first access region 128 (and in the first portion of the third access region 132, where applicable).

The second III-nitride access region layer 204 may be operatively coupled to at least a portion of the second gate structure 112. For example, the second III-nitride access region layer 204 may be (e.g. laterally) operatively coupled to at least a portion of the second III-nitride layer 126. For example, the second III-nitride access region layer 204 may be contiguous (e.g. and distinct from) or continuous with at least a portion of the second III-nitride layer 126. Additionally or alternatively, while not depicted in Fig. 2, the second III-nitride access region layer 204 may be in physical contact with the second gate electrode 116. For example, the second gate electrode 116 may be disposed over and directly on at least a portion of an upper surface of the second III-nitride access region layer 204. Alternatively, it may be that the second gate electrode 116 does not directly contact any part of the upper surface of the second III-nitride access region layer 204.

Accordingly, the second III-nitride access region layer 204 may be at least indirectly biased by the second gate electrode 116 by way of its operative coupling to the second gate structure 112.

It will be appreciated that the dotted lines shown in Fig. 2 at the boundary between the first III-nitride access region layer 202 and the first III-nitride layer 124 and at the boundary between the second III-nitride access region layer 204 and the second III-nitride layer 126 merely schematically demarcate said boundaries. It will be appreciated that similar dotted lines shown in relation to other examples of the III-nitride based bi-directional device 200 similarly merely schematically demarcate corresponding boundaries.

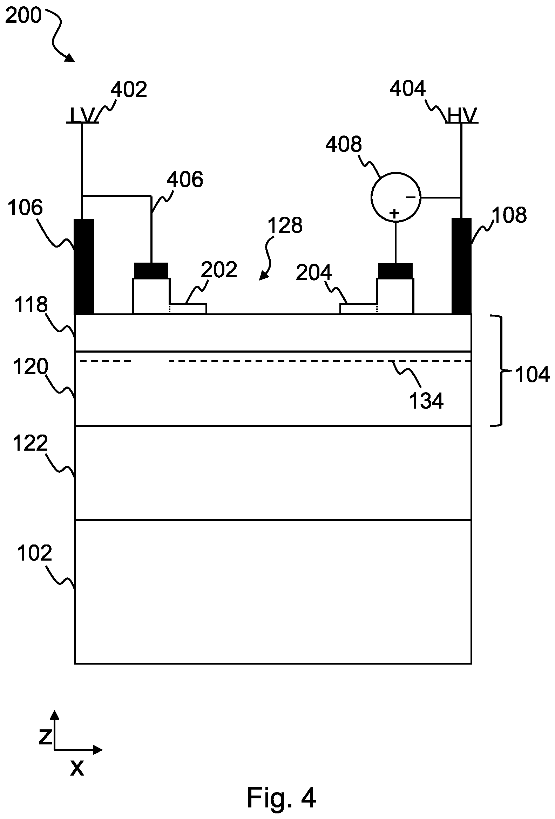

Relative to the III-nitride based bi-directional device 100, the provision of the first and the second III-nitride access region layers 202, 204 in the III-nitride based bi-directional device 200 may serve to reduce a peak intensity of the blocking electric field in the first access region 128 adjacent the low-voltage gate structure, among providing other benefits. This is explained further below with reference to Fig. 4.

**Fig. 3** schematically illustrates another cross-sectional view of the III-nitride based bi-directional device 200 shown in Fig. 2. Various references numerals shown in Fig. 2 have been omitted from Fig. 3 for the purposes of clarity.

The III-nitride based bi-directional device 200 may have a first lateral spacing 302 between the first conduction electrode 106 and the first gate structure 110, a second lateral spacing 304 between the second conduction electrode 108 and the second gate structure 112, a third lateral spacing 306 between the first gate structure 110 and a lateral midpoint of the first access region 128, and a fourth lateral spacing 308 between the second gate structure 112 and the lateral midpoint of the first access region 128.

In the example shown in Fig. 3, the dashed line 310 indicates an axis intersecting the lateral midpoint of the first access region 128. Said axis is oriented in a second direction (e.g. the z direction in Fig. 3) that is orthogonal to the first direction (e.g. the x direction in Fig. 3) in which the first and the second conduction electrodes 106, 108 are laterally spaced apart.

It may be desirable for the III-nitride based bi-directional device 200 to exhibit a (e.g. substantially) equivalent (e.g. symmetrical) electrical performance when conducting or blocking current in either direction. To provide for such an equivalent electrical performance, it may be that each of the first and the second conduction electrodes 106, 108, the first and the second gate structures 110, 112, and the first and the second III-nitride access region layers 202, 204 are configured such that they are (e.g. substantially) the same as each other.

For example, it may be that each of the first and the second conduction electrodes 106, 108, the first and the second gate structures 110, 112, and the first and the second access region layers 202, 204 are configured such that their geometry and/or material composition and/or construction is (e.g. substantially) the same as each other.

Additionally or alternatively, it may be that the III-nitride based bi-directional device 200 is configured such the first and second conduction electrodes 106, 108, the first and the second gate structures 110, 112, and the first and the second III-nitride access region layers 202, 204 are (e.g. substantially) symmetrical about the axis 310. In such examples, it may be that the first lateral spacing 302 is (e.g. substantially) equal to the second lateral spacing 304, and the third lateral spacing 306 is (e.g. substantially) equal to the fourth lateral spacing 308.

However, it is to be understood that the present disclosure is not so limited. For example, one, some, or each of the first and the second conduction electrodes 106, 108, the first and the second gate structures 110, 112, and the first and the second III-nitride access region layers 202, 204 may be configured differently from each other. Additionally, the first lateral spacing 302 may be different from the second lateral spacing 304 and/or the third lateral spacing 306 may be different from the fourth lateral spacing 308.

**Fig. 4** schematically illustrates a cross-sectional view of the III-nitride based bi-directional device 200 when in use. Various references numerals shown in Fig. 2 have been omitted from Fig. 4 for the purposes of clarity.

In the example shown in Fig. 4, the first conduction electrode 106 is electrically coupled to a low-voltage node 402, and the second conduction electrode 108 is electrically coupled to a high-voltage node 404. Accordingly, a positive voltage difference is applied between the first and the second conduction electrodes 106, 108. It is to be understood that the terms low-voltage node and high-voltage node are used to indicate that, with respect to a common reference, a voltage of the low-voltage node 402 is relatively lower than a voltage of the high-voltage node 404. The terms low-voltage node and high-voltage node are not used to refer to any particular voltage values.

In the example shown in Fig. 4, the III-nitride based bi-directional device 200 is operated in the first blocking operating state so as to (e.g. substantially) block a flow of current between the first and the second conduction electrodes 106, 108 in the presence of the positive voltage difference applied therebetween. Accordingly, the first (low-volage) gate structure 110 is biased in its off-state (as schematically illustrated in Fig. 4 by electrical coupling 406 between the conduction electrode 106 and the first gate electrode 114) and the second (high-voltage) gate structure 112 is biased in its on-state (as schematically illustrated in Fig. 4 by voltage source 408 electrically coupled between the second conduction electrode 108 and the second gate electrode 116).

Accordingly, electrons in the channel under the first gate structure 110 are (e.g. substantially) fully depleted (as schematically illustrated in Fig. 4 by the absence of the dashed line 134 in this region). It will be appreciated that while the dashed line 134 is shown in Fig. 4 to be present in other regions of the device 200, this is merely for ease of illustration and is not intended to indicate a presence or a particular concentration of electrons in the channel in these regions of the device 200.

The first III-nitride access region layer 202 may form a third diode-like structure with a portion of the n-type channel underlying the first portion of the first access region 128. The first III-nitride access region layer 202 may be configured such that, when the device 200 is under equilibrium conditions (e.g. when no external voltage is applied to the device 200 e.g. when no external voltage is applied to any one of the first and the second conduction electrodes 106, 108 and the first and the second gate electrodes 114, 116), the third diode-like structure causes at least partial depletion of electrons in the channel in the first portion of the first access region 128. Such depletion of electrons in the channel in the first portion of the first access region 128 under equilibrium conditions may result in a desirable reshaping of the blocking electric field in the first access region 128 when the device 200 is operated as depicted in Fig. 4. Such reshaping of the blocking electric field may advantageously act to reduce its peak intensity adjacent the first (low-voltage) gate structure 110 and provide for a more uniform distribution of the blocking electric field throughout the first access region 128, for example.

Additionally, when the III-nitride based bi-directional device is operated as depicted in Fig. 4, the third diode-like structure may be biased (by way of the operative coupling between the first gate structure 110 and the first III-nitride access region layer 202) so as to (e.g. at least partially) deplete holes in the first III-nitride access region layer 202. Such depletion of holes in the first III-nitride access region layer 202 may result in the first III-nitride access region layer 202 acting as a (e.g. depletable) field plate, which may additionally act to desirably reshape or modulate the blocking electric field in the first access region 128.

The second III-nitride access region layer 204 may form a fourth diode-like structure with a portion of the n-type channel underlying the second portion of the first access region 128. When the III-nitride based bi-directional device is operated as depicted in Fig. 4, the biasing of the second gate structure 112 in its on state may in turn bias the fourth diode-like structure (by way of the operative coupling between the second gate structure 112 and the second III-nitride access region layer 204) so as to accumulate holes in the second III-nitride access region layer 204. This accumulation of holes in the second III-nitride access region layer 204 may give rise to an injection of holes from the second III-nitride access region layer 204 into the portion of the III-nitride heterostructure 104 underlying the second III-nitride access region layer 204, which may provide various benefits. For example, such hole injection into the III-nitride heterostructure 104 may provide a screening effect mitigating against electrons in the channel being captured by surface traps of the III-nitride heterostructure 104. Additionally or alternatively, such hole injection may provide recombination centres by which electrons trapped in the III-nitride heterostructure 104 may de-trap.

Furthermore, the above-described accumulation of holes in the second III-nitride access region layer 204 may result in the second III-nitride access region layer 204 acting as a (e.g. high-voltage) field plate, the potential of which may be (e.g. substantially) equal to the potential of the second gate electrode 116 of the second (high-voltage) gate structure 112.

In examples wherein the first and the second field plates 206, 208 are present and are configured to extend over at least a portion of the first and the second III-nitride access region layers 202, 204, respectively, the above-described operation of the second III-nitride access region layer 204 may provide a further benefit. In the absence of access region layers such as the first and the second III-nitride access region layers 202, 204, employing field plates, such as the first and the second field plates 206, 208 in a bi-directional device, such as the III-nitride based bi-directional device 100, may be problematic. This is because while the field plate electrically coupled to the low-voltage conduction electrode may reduce the electric field intensity adjacent the low-voltage gate structure, the field plate electrically coupled to the high-voltage conduction electrode may give rise to electron trapping adjacent the high-voltage gate structure. However, when the III-nitride based bi-directional device 200 is operated in the presence of the positive voltage difference described above and in the first blocking operating state, the accumulation of holes and/or the injection of holes provided by the second III-nitride access region layer 204 may mitigate against electron trapping due to the second (high-voltage) field plate 208. Accordingly, the provision of the first and the second III-nitride access region layers 202, 204 may enable field plates such as the first and the second field plates 206, 208 to be employed, which may serve to additionally reduce the peak blocking electric field intensity in the first access region 128 relative to instances of the device 200 omitting such field plates.

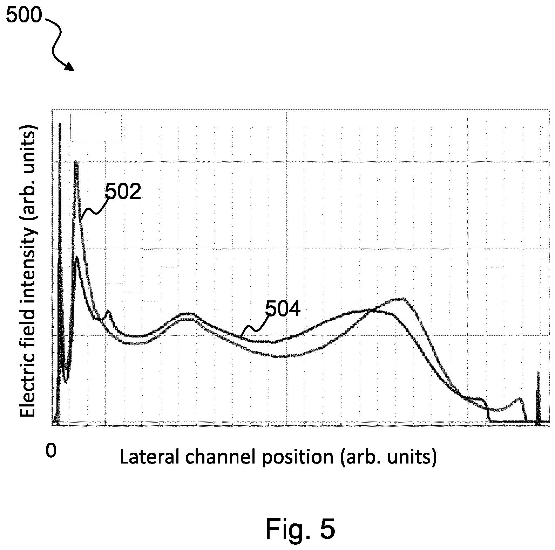

**Fig. 5** illustrates a graph 500 comparing a simulated electric field intensity in the channel of the III-nitride based bi-directional device 100 and the III-nitride based bi-directional device 200 when both devices are operated in the first blocking operating state in the presence of an equivalent positive voltage difference. The graph 500 was generated by way of technology computer aided design (TCAD) simulation. The x-axis represents the lateral position in the first access region 128 of the III-nitride based bi-directional devices 100, 200. The zero point on the x-axis corresponds to an edge of the low-voltage gate structure (the first gate structure 110) adjacent the first access region 128 of the III-nitride based bi-directional devices 100, 200. The y-axis represents electric field intensity. The trace 502 corresponds to the III-nitride based bi-directional device 100 and the trace 504 corresponds to the III-nitride based bi-directional device 200. It can be seen from the graph 500 that the provision of the first and the second III-nitride access region layers 202, 204 in the III-nitride based bi-directional device 200 acts to provide a more uniform electric field intensity in the channel in the first access region 128 and to reduce the peak electric field intensity adjacent the low-voltage gate structure.

While the above functionality of the first and the second III-nitride access region layers 202, 204 has been described with reference to the first blocking operating state in the presence of a positive voltage difference applied between the conduction electrodes 106, 108, it is to be understood that the same or similar benefits to those discussed above with reference to Figs. 4 to 5 are also provided by the first and the second III-nitride access region layers 202, 204 when the III-nitride based bi-directional device 200 is operated in the second blocking operating state in the presence of a negative voltage difference applied between the conduction electrodes 106, 108, or in the third blocking operating state in the presence of a positive or a negative voltage difference applied between the conduction electrodes 106, 108.

For example, when the III-nitride based bi-directional device 200 is operated in the second blocking operating state in the presence of a negative voltage difference applied between the conduction electrodes 106, 108, the functionality of the first and the second III-nitride access region layers 202, 204 described above in relation to Fig. 4 may reverse so as to provide the same benefits as described above.

When the III-nitride based bi-directional device 200 is operated in the third blocking operating state in the presence of either a negative or a positive voltage difference applied between the conduction electrodes 106, 108, similar benefits to those described above in relation to the first and the second blocking operating states are provided. It will be appreciated that, in the third blocking operating state, while the high-voltage gate structure is biased in its off-state, holes may still accumulate in the III-nitride access region layer operatively coupled thereto. This is because holes may diffuse from a corresponding one of the first and second p-type III-nitride layers 124, 126 of the high-voltage gate structure to said III-nitride access region layer.

As discussed above, the functionality of each of the first and the second gate structures 110, 112 and the first and the second III-nitride access region layers 202, 204 may be enabled by way of respective p-type III-nitride layers, each of which may be configured to selectively deplete electrons in the channel, at least under certain bias conditions. One solution for implementing the first and the second III-nitride access region layers 202, 204 may be to employ extended variants of the first and the second III-nitride layers 124, 126 extending over and being operatively coupled to the first and the second portions of the first access region 128, respectively. However, such a solution may be sub-optimal. This is because it may be desirable for the first and the second Ill-nitride layers 124, 126 to have different characteristics from the first and the second III-nitride access region layers 202, 204 in order to optimize the respective functions of the various layers.

To this end, the Ill-nitride access region layers 202, 204 may be configured differently from the first and the second III-nitride layers 124, 126, such as in terms of, for example, any one or more of: their material composition; their doping concentration; their thickness; a thickness of a III-nitride barrier through which they are operatively coupled to the channel.

For example, it may be that a (e.g. average) acceptor doping concentration of each of the first and the second III-nitride access region layers 202, 204 is less than a (e.g. average) acceptor doping concentration of the first and the second III-nitride layers 124, 126. For example, the (e.g. average) acceptor concentration of the first and the second III-nitride layers 124, 126 of the first and the second gate structures 110, 112 may have a first value in the range of (e.g. about) 1x10¹⁹ cm⁻³ to (e.g. about) 5x10¹⁹ cm⁻³ inclusive, and the (e.g. average) acceptor concentration of the first and the second III-nitride access region layers 202, 204 may have a second value, less than the first value. For example, the second value may be in the range of (e.g. about) 1x10¹⁶ cm⁻³ to (e.g. about) 1x10¹⁹ cm⁻³ inclusive or at least a portion thereof having an upper bound lower than the first value. It may be that the second value is less than 1x10¹⁹ cm⁻³, for example. The inventors have found that employing such lower doping concentrations in the III-nitride access region layers 202, 204 than in the first and the second III-nitride layers 124, 126 may enable a suitably positive threshold voltage of the enhancement mode gate structures 110, 112 while additionally providing for or contributing to a desirable blocking electric field distribution in the first access region 128, such as in terms of peak electric field intensity and uniformity.

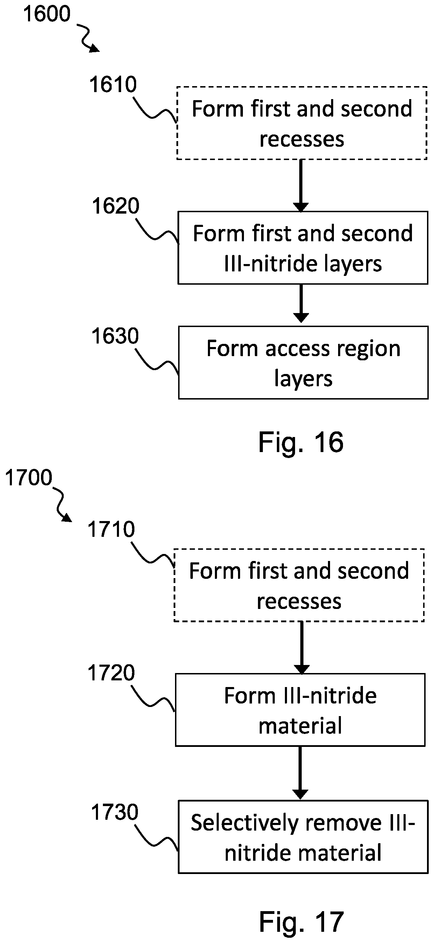

In such examples, the different doping concentrations of the III-nitride access region layers 202, 204 and the first and the second III-nitride layers 124, 126 may be formed by any suitable method. Examples of such methods are discussed in relation to Figs. 16 to 18, and 20. However, it is to be understood that the present disclosure is not so limited and that the above-described doping concentrations may be formed in any other suitable way.

In addition to or as an alternative to employing different doping concentrations in the first and the second III-nitride access region layers 202, 204 and the first and second III-nitride layers 124, 126 as described above, it may be that a (e.g. average) thickness of the first III-nitride access region layer 202 is less than a (e.g. average) thickness of the first III-nitride layer 124. Additionally, a (e.g. average) thickness of the second III-nitride access region layer 204 may be less than a (e.g. average) thickness of the second III-nitride layer 126.

For example, a (e.g. average) thickness of the first and the second III-nitride layers 124, 126 may be in the range of (e.g. about) 200 nm to (e.g. about) 400 nm inclusive while a (e.g. average) thickness of the first and the second III-nitride access region layers 202, 204 may be in the range of (e.g. about) 10 nm to (e.g. about) 100 nm inclusive.

As with employing different doping concentrations in the first and the second III-nitride access region layers 202, 204 and the first and the second III-nitride layers 124, 126, the inventors have found that employing different thicknesses of the first and the second III-nitride access region layers 202, 204 relative to the first and the second III-nitride layers 124, 126, such as those described above, may enable a suitably positive threshold voltage of the enhancement mode gate structures 110, 112 while additionally providing for or contributing to a desirable blocking electric field distribution in the first access region 128.

Such different thicknesses of the III-nitride access region layers 202, 204 and the first and the second III-nitride layers 124, 126 may be formed by any suitable method. Examples of such methods are discussed in relation to Figs. 16 to 18, and 20. However, it is to be understood that the present disclosure is not so limited and other methods may be employed. It will be appreciated that while the first and the second III-nitride access region layers 202, 204 are schematically illustrated in various figures of the present disclosure to have different thicknesses from each other, this is merely for illustrative purposes and the present disclosure is not so limited.

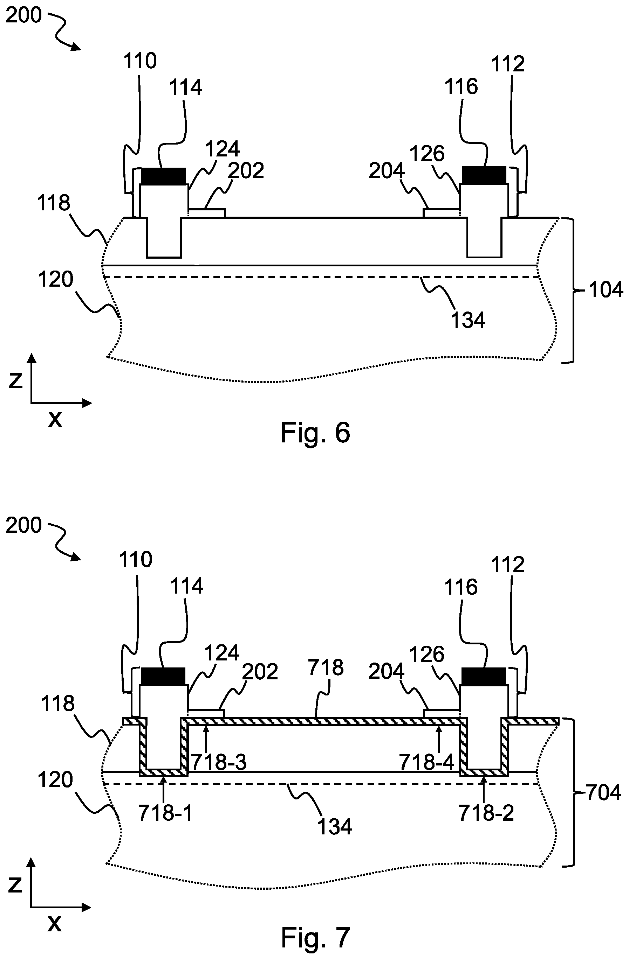

Further example configurations of the first and the second gate structures 110, 112 and the first and the second III-nitride access region layers 202, 204 of the III-nitride based bi-directional device 200 are now discussed with reference to Figs. 6 to 13. It is to be understood that, unless incompatible, any one or more of the features or the elements discussed herein in relation to Figs. 1 to 5 may be combined in any combination with any one or more of the features or the elements discussed in the following in relation to Figs. 6 to 13. Similarly, unless incompatible, any one or more of the features or the elements discussed in relation to Figs. 6 to 13 may be combined with each other in any combination.

In any of the examples described herein, the first and the second III-nitride access region layers 202, 204 may have any suitable length (i.e. as measured with respect to the first (e.g. x) direction). As an illustrative example, the III-nitride access region layers 202, 204 may each have a length in the range of (e.g. about) 300 nm to (e.g. about) 3 µm inclusive, such as in the range of (e.g. about) 500 nm to (e.g. about) 2 µm inclusive. The inventors have found that, in general, and in particular in examples where the device 200 is configured for medium and high-voltage applications, such lengths of the III-nitride access region layers 202, 204 may be beneficial. For example, such lengths of the III-nitride access region layers 202, 204 may provide a desirable blocking electric field distribution and may additionally desirably limit the amount of excess charge required to switch the first and the second gate structures 110, 112 between their on states and off states, which may increase with increasing lengths of the first and the second III-nitride access region layers 202, 204.

Additionally or alternatively, in any of the examples described herein, the first and the second III-nitride access region layers 202, 204 may be configured to, when the III-nitride based bi-directional device 200 is under equilibrium conditions, partially (and not fully) deplete electrons in the channel in the first and second portions of the first access region 128, respectively. The inventors have found that such partial (and not full) depletion of electrons in these regions of the channel under equilibrium conditions may be beneficial for reshaping the blocking electric field in the first access region 128 to reduce its peak intensity.

Additionally or alternatively, in any of the examples described herein, when the III-nitride based bi-directional device 200 is operated in an on-state (i.e. in the first conducting operating state in the presence of a voltage difference applied between the first and the second conduction electrodes 106, 108), the first and the second III-nitride access region layers 202, 204 may be configured to accumulate electrons in the channel in at least the first and the second portions of the first access region 128, respectively, such that a concentration of electrons in the channel in said portions of the first access region 128 is greater than if the first and second III-nitride access region layers 202, 204 were absent. Accordingly, when the device 200 is operated in the on-state, the provision of the first and the second III-nitride access region layers 202, 204 may advantageously reduce at least a local resistivity of the channel in the first and the second portions of the first access region 128.

Additionally or alternatively, in any of the examples described herein, the (e.g. thickness and doping concentration of the) first III-nitride access region layer 202 may be configured such that it is (e.g. substantially) fully depleted of charge carriers (holes) when the first gate structure 110 is biased in its off-state, or at least when first gate structure 110 is biased in its off-state and a voltage difference (such as a medium or a high-voltage difference, e.g. depending on an application for which the device 200 is configured) is applied between the first and the second conduction electrodes 106, 108. Similarly, it may be that the (e.g. thickness and doping concentration of the) second III-nitride access region layer 204 is configured such that it is (e.g. substantially) fully depleted of charge carriers (holes) when the second gate structure 112 is biased in its off-state, or at least when the second gate structure 112 is biased in its off-state and a (e.g. medium or high) voltage difference is applied between the first and the second conduction electrodes 106, 108. Such configurations of the III-nitride access region layers 202, 204 may be beneficial for reducing a peak intensity of the blocking electric field in the first access 128.

**Fig.** 6 schematically illustrates an example cross-sectional view of a portion of another example of the III-nitride based bi-directional device 200. In the example of the III-nitride based bi-directional device 200 shown in Fig. 6, the first III-nitride layer 124 is at least partially disposed in a first recess formed in the III-nitride barrier layer 118, and the second III-nitride layer 126 is at least partially disposed in a second recess formed in the III-nitride barrier layer 118.

Each of the first and the second recesses may comprise a bottom portion and sidewall portions. The first recess may be formed in at least part of the first gate region and the second recess may be formed in at least part of the second gate region. Each of the first and the second recesses may extend partially through the Ill-nitride barrier layer 118. Accordingly, each of the bottom and sidewall portions of the first and the second recesses may be formed from the III-nitride barrier layer 118.

Disposing the first and the second III-nitride layers 124, 126 at least partially within the first and second recesses described above may result in the first and the second III-nitride layers 124, 126 being operatively coupled with the channel through a thinner portion of the III-nitride barrier layer 118 than the first and the second III-nitride access region layers 202, 204. This in turn may enable the first and second gate structures 110, 112 to provide for enhancement mode operation while enabling the first and second access region layers 202, 204 to partially (and not fully) deplete electrons in underlying portions of the channel when the device 200 is under equilibrium conditions. Such partial depletion of electrons in the channel in the first access region 128 under these conditions may provide for a desirable blocking electric field distribution in the first access region 128, as discussed above.

**Fig.** 7 schematically illustrates an example cross-sectional view of a portion of another example of the III-nitride based bi-directional device 200. The example of the III-nitride based bi-directional device 200 shown in Fig. 7 corresponds to the example device 200 shown in Fig. 6 with the following exceptions.

In the example shown in Fig. 7, the device 200 includes a III-nitride heterostructure 704, which is a variation of the III-nitride heterostructure 104 discussed herein. In the example shown in Fig. 7, the III-nitride barrier layer 118 is a first III-nitride barrier layer of the III-nitride heterostructure 704 and the III-nitride heterostructure 704 further comprises a second III-nitride barrier layer 718.

The second III-nitride barrier layer 718 may comprise or consist of any suitable III-nitride material, such as AlGaN (of any suitable molar composition), for example. It may be that the second III-nitride barrier layer 718 has a higher molar fraction of a secondary type III element (e.g. aluminium in the case of AlGaN) than the first III-nitride barrier 118. The thickness of the second III-nitride barrier 718 is less than a thickness of the first III-nitride barrier layer 118.

In the example shown in Fig. 7, each of the first and second recesses formed in the first II-nitride barrier layer 118 extend through an entire thickness of the first III-nitride barrier layer 118 and may optionally extend into respective underlying portions of the III-nitride channel layer 120. Accordingly, the first and the second recesses correspond to regions where the first III-nitride barrier layer 118 has been entirely removed.

The second III-nitride barrier layer 718 may be disposed in and may (e.g. substantially conformally) line each of the first and second recesses. For example, the second III-nitride barrier layer 718 may include at least a first portion 718-1 disposed over the bottom portion and along the sidewalls of the first recess, and a second portion 718-2 disposed over the bottom portion and along the sidewalls of the second recess.

Additionally, the second III-nitride barrier layer 718 may include a third portion 718-3 disposed between the first III-nitride access region layer 202 and the first III-nitride barrier layer 118, and a fourth portion 718-4 disposed between the second III-nitride access region layer 204 and the first III-nitride barrier layer 118.

Additionally, the second Ill-nitride barrier layer 718 may include a (not shown) portion disposed over the first electrode region between the first conduction electrode 106 and the first III-nitride barrier layer 118, and a (not shown) portion disposed over the second electrode region between the second conduction electrode 108 and the first III-nitride barrier layer 118.

As will be discussed further below, the second III-nitride barrier layer 718 may be a so-called "regrown" layer which may be grown following formation of the first and the second recesses in the first III-nitride barrier layer 118.

The first III-nitride layer 124 may be at least partially disposed in the first recess and may be disposed on the first portion 718-1 of the second III-nitride barrier layer 718. The second III-nitride layer 126 may be at least partially disposed in the second recess and may be disposed on the second portion 718-2 of the second III-nitride barrier layer 718.

Accordingly, of the first III-nitride barrier layer 118 and the second III-nitride barrier layer 818, the first and the second III-nitride layers 124, 126 may be operatively coupled to the channel through the second III-nitride barrier 718 only, whereas the first and the second III-nitride access region layers 202, 204 may be operatively coupled to the channel through both the first and the second III-nitride barrier layers 118, 718. This in turn may enable the first and second gate structures 110, 112 to provide for enhancement mode operation while enabling the first and second access region layers 202, 204 to advantageously partially (and not fully) deplete electrons in underlying portions of the channel when the device 200 is under equilibrium conditions.

Additionally, the architecture of the example III-nitride based bi-directional device 200 shown in Fig. 7 may provide for further benefits.

For example, it has been observed that configuring the first and the second III-nitride layers 124, 126 such that they modulate (e.g. deplete or accumulate) electrons in the channel through the second (e.g. regrown) III-nitride barrier layer 718 instead of through recesses extending only partially through the III-nitride barrier layer 118 (such as is the case in the example device 200 shown in Fig. 7) may beneficially result in a reduced threshold voltage variability between different instances of the device 200.

Additionally, in examples where the second III-nitride barrier 718 layer includes the above-described portions disposed between each the first and the second conduction electrodes 106, 108 and the first III-nitride barrier layer 118, the provision of the second Ill-nitride barrier layer 718 in these regions may serve to reduce a contact resistance of the first and the second conduction electrodes 106, 108 by way of increasing a thickness of III-nitride barrier material disposed thereunder.

Additionally, in examples where the second III-nitride barrier layer 718 has a higher molar fraction of a secondary type III element than the first III-nitride barrier layer 118, it has been observed that, relative to examples of the device 200 employing a single barrier layer only, the provision of the second III-nitride barrier layer 718 may provide a beneficial increase in saturation current while maintaining suitable threshold voltages of the first and the second gate structures 110, 112.

While the second III-nitride barrier layer 718 is illustrated in Fig. 7 as a single continuous layer, it will be appreciated that the present disclosure is not so limited. The second III-nitride barrier layer 718 may be a single continuous layer including the portions described above. Alternatively, the second III-nitride barrier layer 718 may be a discontinuous layer comprising at least the first portion 718-1 and the second portion 718-2, and optionally any one or more of the other portions described above, such as the portions 718-3 and 718-4, for example.

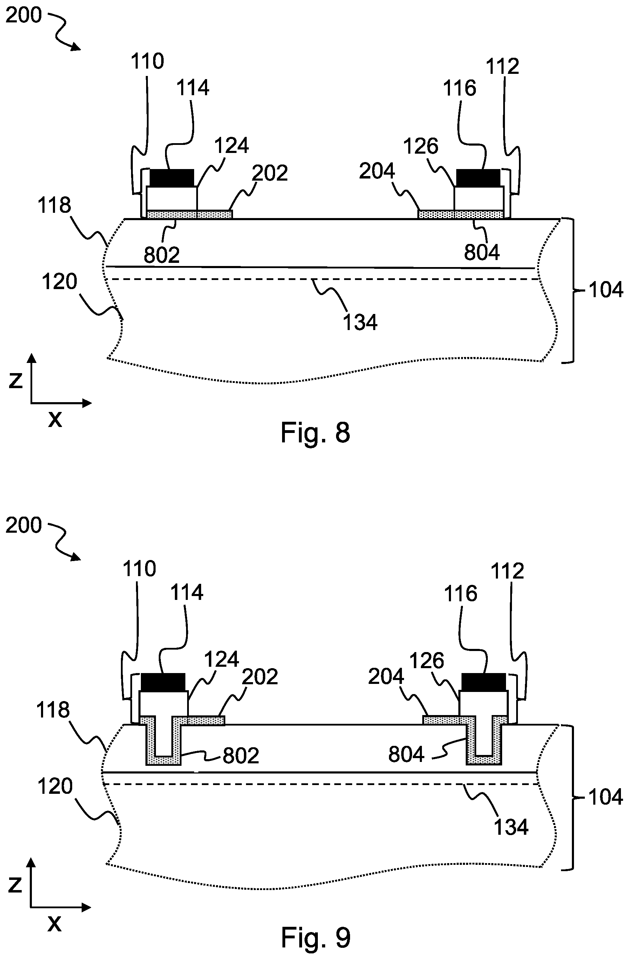

**Fig.** 8 schematically illustrates an example cross-sectional view of a portion of another example of the III-nitride based bi-directional device 200.

In the example shown in Fig. 8, the III-nitride based bi-directional device 200 comprises a third p-type III-nitride layer 802 disposed over the first gate region between the first III-nitride layer 124 and the III-nitride barrier layer 118. The third III-nitride layer 802 is continuous with the first III-nitride access region layer 202. Accordingly, a material composition of the third III-nitride layer 802 may be the same as that of the first III-nitride access region layer 202.

Additionally, in the example shown in Fig. 8, the III-nitride based bi-directional device 200 comprises a fourth p-type III-nitride layer 804 disposed over the second gate region between the second III-nitride layer 126 and the III-nitride barrier layer 118. The fourth III-nitride layer 804 is continuous with the second III-nitride access region layer 204. Accordingly, a material composition of the fourth III-nitride layer 804 may be the same as that of the second III-nitride access region layer 204.

In the example shown in Fig. 8, a thickness of the first access region layer 202 (which may be (e.g. substantially) the same as that of the third III-nitride layer 802) may be less than a thickness of the first III-nitride layer 124, in accordance with examples disclosed herein. Additionally or alternatively, an acceptor doping concentration of the first access region layer 202 (which may be (e.g. substantially) the same as that of the third III-nitride layer 802) may be less than an acceptor doping concentration of the first III-nitride layer 124, in accordance with examples disclosed herein.

Additionally, a thickness of the second III-nitride access region layer 204 (which may be (e.g. substantially) the same as that of the fourth III-nitride layer 804) may be less than a thickness of the second III-nitride layer 126, in accordance with examples disclosed herein. Additionally or alternatively, an acceptor doping concentration of the second III-nitride access region layer 204 (which may be (e.g. substantially) the same as that of the fourth III-nitride layer 804) may be less than an acceptor doping concentration of the second III-nitride layer 126, in accordance with examples disclosed herein.

In the example shown in Fig. 8, because the III-nitride access region layers 202, 204 are separate and distinct layers from the first and the second III-nitride layers 124, 126, the material parameters of these layers may be independently controlled. Accordingly, the architecture of the example device 200 shown in Fig. 8 may enable III-nitride access region layers having thicknesses and/or doping concentrations that are arbitrarily different from those of the first and the second III-nitride layers 124, 126 to be efficiently fabricated. This in turn may enable the characteristics of each of these layers to be independently optimised for their respective functions.

**Fig.** 9 schematically illustrates an example cross-sectional view of a portion of another example of the III-nitride based bi-directional device 200. The example of the III-nitride based bi-directional device 200 shown in Fig. 9 corresponds to the example device 200 shown in Fig. 6 with the exception that example device 200 shown in Fig. 9 additionally includes the third and the fourth p-type III-nitride layers 802, 804 described above in relation to Fig. 8.

In the example shown in Fig. 9, the third III-nitride layer 802 may be disposed in and may (e.g. substantially conformally) line the first recess. For example, the third III-nitride layer 802 may be disposed over the bottom portion and along the sidewalls of the first recess. The first III-nitride layer 124 may be disposed at least partially in the first recess and may be disposed on the third III-nitride layer 802.

Additionally, the fourth III-nitride layer 804 may be disposed in and may (e.g. substantially conformally) line the second recess. For example, the fourth III-nitride layer 804 may be disposed over the bottom portion and along the sidewalls of the second recess. The second III-nitride layer 126 may be disposed at least partially in the second recess and may be disposed on the fourth III-nitride layer 804.

The architecture of the III-nitride based bi-directional device 200 shown in Fig. 9 may provide for each of the various benefits discussed above in relation to the examples of the III-nitride based bi-directional device 200 shown in Figs. 6 and 8.

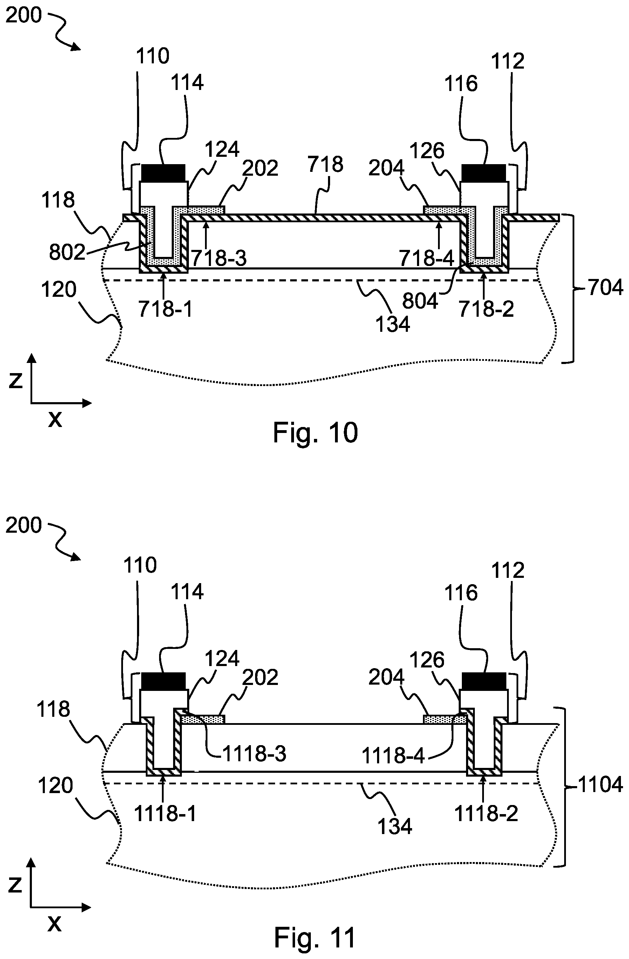

**Fig.** 10 schematically illustrates an example cross-sectional view of a portion of another example of the III-nitride based bi-directional device 200. The example of the III-nitride based bi-directional device 200 shown in Fig. 10 corresponds to the example device 200 shown in Fig. 7 with the exception that the example device 200 shown in Fig. 10 additionally includes the third and the fourth p-type III-nitride layers 802, 804 described above in relation to Fig. 8.

In the example shown in Fig. 10, the third III-nitride layer 802 may be disposed in the first recess and may be disposed on the first portion 718-1 of the second III-nitride barrier layer 718. For example, the third p-type III-nitride layer 802 may (e.g. substantially conformally) line the first portion 718-1 of the second III-nitride barrier layer 718. The first III-nitride layer 124 may be at least partially disposed in the first recess and may be disposed on the third III-nitride layer 802.

Additionally, the fourth III-nitride layer 804 may be disposed in the second recess and may be disposed on the second portion 718-2 of the second III-nitride barrier layer 718. For example, the fourth III-nitride layer 804 may (e.g. substantially conformally) line the second portion 718-2 of the second III-nitride barrier 718. The second p-type III-nitride layer 126 may be disposed at least partially in the second recess and may be disposed on the fourth Ill-nitride layer 804.

The architecture of the III-nitride based bi-directional device 200 shown in Fig. 10 may provide for each of the various benefits discussed above in relation to the examples of the III-nitride based bi-directional device 200 shown in Figs. 7 and 8.

**Fig. 11** schematically illustrates an example cross-sectional view of a portion of another example of the III-nitride based bi-directional device 200.

In the example shown in Fig. 11, the device 200 includes a III-nitride heterostructure 1104, which is a variation of the III-nitride heterostructure 104 discussed herein. In the example shown in Fig. 11, the III-nitride barrier layer 118 is a first III-nitride barrier layer of the III-nitride heterostructure 1104 and the III-nitride heterostructure 1104 further comprises a second III-nitride barrier layer 1118. The second III-nitride barrier layer 1118 may be similar to the second III-nitride barrier layer 718, such as in terms of its material composition and geometry. Accordingly, such aspects of the second III-nitride barrier layer 1118 will not be described separately here.

In the example shown in Fig. 11, a first recess is formed in the first III-nitride barrier layer 118 in at least a portion of the first gate region, and a second recess is formed in the first III-nitride barrier layer 118 in at least a portion of the second gate region. Each of the first and the second recesses may comprise a bottom portion and sidewall portions. Each of the first and second recesses extend through an entire thickness of the first III-nitride barrier layer 118 and may optionally extend into respective underlying portions of the III-nitride channel layer 120. Accordingly, the first and second recesses correspond to regions where the first III-nitride barrier layer 118 has been entirely removed.

The second III-nitride barrier layer 1118 may be disposed in and may (e.g. substantially conformally) line each of the first and second recesses. For example, the second III-nitride barrier layer 1118 may include at least a first portion 1118-1 disposed over the bottom portion and along the sidewalls of the first recess, and a second portion 1118-2 disposed over the bottom portion and along the sidewalls of the second recess.

Additionally, the second III-nitride barrier layer 1118 may include a third portion 1118-3 disposed adjacent to and extending at least partially over the first III-nitride access region layer 202. Accordingly, the first III-nitride access region layer 202 may be operatively coupled to the first III-nitride layer 124 of the first gate structure 110 by way of the second III-nitride barrier layer 1118. The third portion 1118-3 of the second III-nitride barrier layer 1218 may extend from and may be continuous with the first portion 1118-1 of the second III-nitride barrier layer 1118.

Additionally, the second III-nitride barrier layer 1118 may include a fourth portion 1118-4 disposed adjacent to and extending at least partially over the second III-nitride access region layer 204. Accordingly, the second III-nitride access region layer 204 may be operatively coupled to the second III-nitride layer 126 of the second gate structure 112 by way of the second III-nitride barrier layer 1118. The fourth portion 1118-4 of the second III-nitride barrier layer 1118 may extend from and may be continuous with the second portion 1118-2 of the second III-nitride barrier layer 1118.

The first III-nitride layer 124 may be disposed at least partially in the first recess and may be disposed on the first portion 1118-1 of the second III-nitride barrier layer 1118. The second III-nitride layer 126 may be disposed at least partially in the second recess and may be disposed on the second portion 1118-2 of the second III-nitride barrier layer 1118.

The architecture of the example III-nitride based bi-directional device 200 shown in Fig. 11 may provide for various benefits. For example, the provision of the second III-nitride barrier layer 1118 may provide for similar benefits to those described above in relation to the second III-nitride barrier layer 718 shown in Fig. 7.

Additionally, because the III-nitride access region layers 202, 204 are separate and distinct layers from the first and the second III-nitride layers 124, 126, the architecture of the example device 200 shown in Fig. 11 may enable the material parameters of these layers to be independently controlled. Accordingly, the example III-nitride based bi-directional device 200 shown in Fig. 11 may provide for similar benefits to those discussed in relation to the III-nitride based bi-directional device 200 shown in Fig. 8.

While it is illustrated in Fig. 11 that the first III-nitride access region layer 202 is directly adjacent an edge of the first recess and that the second III-nitride access region layer 204 is directly adjacent an edge of the second recess, it will be appreciated that this is merely for illustrative purposes and that the present disclosure is not so limited. For example, the first III-nitride access region layer 202 may be disposed directly adjacent an edge of the first recess, and the second III-nitride access region layer 204 may be disposed directly adjacent an edge of the second recess. Alternatively, there may be a first lateral distance separating the first III-nitride access region layer 202 and a nearest edge of the first recess, and there may be a second lateral distance separating the second III-nitride access region layer 204 and a nearest edge of the second recess. Such lateral distances may be designed to accommodate alignment error that may occur during fabrication of the device 200, such as during lithographic patterning of an etch mask for forming the first and the second recesses, for example. Each of the first and the second lateral distances may be of any suitable size. For example, each of the first and the second lateral distances may be less than or equal to (e.g. about) 300 nm.

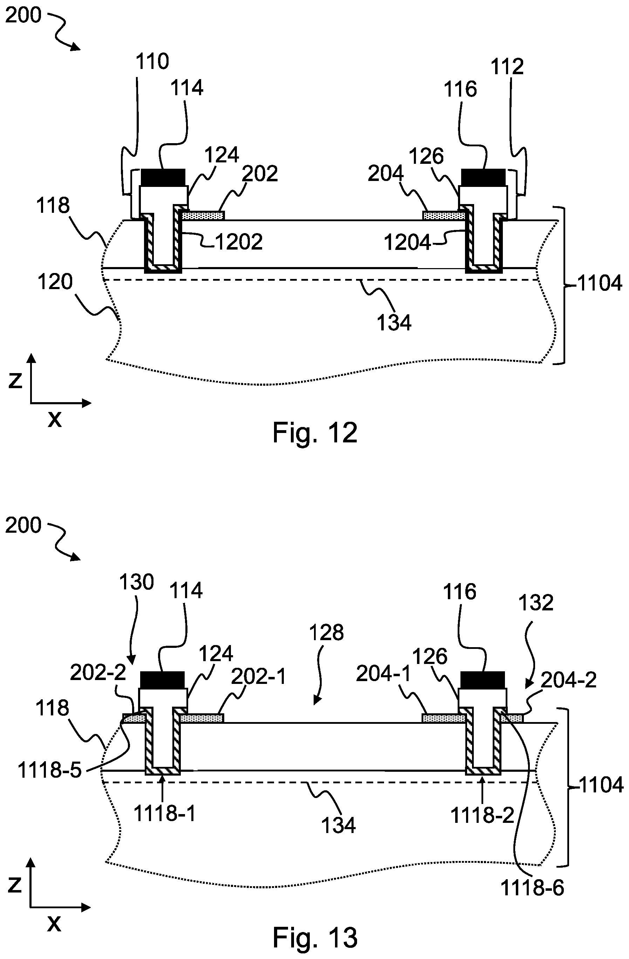

**Fig. 12** schematically illustrates an example cross-sectional view of a portion of another example of the III-nitride based bi-directional device 200. The example of the III-nitride bi-directional device 200 shown in Fig. 12 corresponds to the example device 200 shown in Fig. 11 with the following exceptions. Various references numerals shown in Fig. 11 have been omitted from Fig. 12 for the purposes of clarity

The example III-nitride bi-directional device 200 shown in Fig. 12 includes a first AIN layer 1202 and a second AIN layer 1204. The first AIN layer 1202 is disposed between: the first portion 1118-1 of the second III-nitride barrier layer 1218 and the bottom portion and sidewalls of the first recess; and the third portion 1118-3 of the second III-nitride barrier layer 1118 and the first III-nitride access region layer 202. The second AIN layer 1204 is disposed between: the second portion 1118-2 of the second III-nitride barrier layer 1118 and the bottom portion and sidewalls of the second recess; and the fourth portion 1118-4 of the second III-nitride barrier layer 1118 and the second III-nitride access region layer 204.

Each of the first and the second AIN layers 1202, 1204 may have any suitable thickness. As an illustrative example, a thickness each of the first and the second AIN layers 1202, 1204 may be less than 10 nm, such as in the range of (e.g. about) 0.5 nm to (e.g. about) 5 nm, inclusive, such as a (e.g. about) 0.5 nm to (e.g. about) 2 nm inclusive, such as (e.g. about) 1nm.

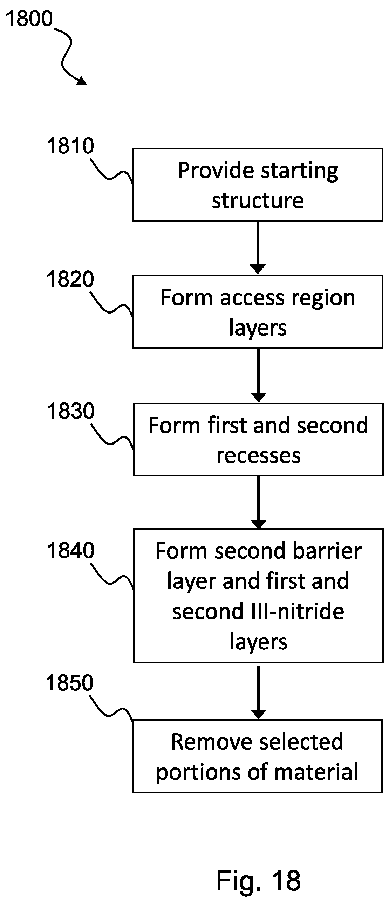

As will be discussed further below in relation to Fig. 18, the provision of the first and the second AIN layers 1202, 1204 may be beneficial for fabricating the III-nitride based bi-directional device 200.

**Fig. 13** schematically illustrates an example cross-sectional view of a portion of another example of the III-nitride based bi-directional device 200. The example of the III-nitride based bi-directional device 200 shown in Fig. 13 corresponds to the example device 200 shown in Fig. 11 with the following exceptions. Various references numerals shown in Fig. 11 have been omitted from Fig. 13 for the purposes of clarity.

In the example shown in Fig. 13, the first III-nitride access region layer 202 includes a first portion 202-1 and second portion 202-2. The first portion 202-1 of the first III-nitride access region layer is disposed over the first portion of the first access region 128 described hereinabove. The second portion 202-2 of the first III-nitride access region layer 202 is disposed over the first portion of the second access region 130 described hereinabove.

In the example shown in Fig. 13, the second III-nitride barrier layer 1118 additionally includes a fifth portion 1118-5 disposed adjacent to and extending at least partially over the second portion 202-2 of the first III-nitride access region layer 202. Accordingly, the second portion 202-2 of the first III-nitride access region layer 202 may be operatively coupled to the first III-nitride layer 124 of the first gate structure 110 by way of the second III-nitride barrier layer 1118. The fifth portion 1118-5 of the second III-nitride barrier layer 1118 may extend from and may be continuous with the first portion 1118-1 of the second III-nitride barrier layer 1118.

The second III-nitride access region layer 204 includes a first portion 204-1 and a second portion 204-2. The first portion 204-1 of the second III-nitride access region layer 204 is disposed over the second portion of the first access region 128 described hereinabove. The second portion 204-2 of the second III-nitride access region layer 204 is disposed over the first portion of the third access region 132 described hereinabove.

In the example shown in Fig. 13, the second III-nitride barrier layer 1118 additionally includes a sixth portion 1118-6 disposed adjacent to and extending at least partially over the second portion 202-4 of the second III-nitride access region layer 204. Accordingly, the second portion 204-2 of the second III-nitride access region layer 204 may be operatively coupled to the second III-nitride layer 126 of the second gate structure 112 by way of the second III-nitride barrier layer 1118. The sixth portion 1118-6 of the second III-nitride barrier layer 1118 may extend from and may be continuous with the second portion 1118-2 of the second Ill-nitride barrier layer 1118.

The example device 200 shown in Fig. 13 may provide for at least similar benefits to those described above in relation to the example device 200 shown in Fig. 11.

While not depicted in Fig. 13, it will be appreciated that the example III-nitride based bi-directional device 200 shown in Fig. 13 may additionally comprise a first AIN layer and a second AIN layer. The first AIN layer may be similar to the first AIN layer 1202 described above in relation to Fig. 12. The second AIN layer may be similar to the second AIN layer 1204 described above in relation to Fig. 12.

When present, the first AIN layer may be disposed between: the first portion 1118-1 of the second III-nitride barrier layer 1118 and the bottom portion and sidewalls of the first recess; the third portion 1118-3 of the second III-nitride barrier layer 1118 and the first portion 202-1 of the first III-nitride access region layer 202; and the fifth portion 1118-5 of the second III-nitride barrier layer 1118 and the second portion 1302-2 of the first III-nitride access layer 202.

When present, the second AIN layer may be disposed between: the second portion 1118-2 of the second III-nitride barrier 1118 and the bottom portion and sidewalls of the second recess; the fourth portion 1118-4 of the second III-nitride barrier layer 1118 and the first portion 204-1 of the second III-nitride access region layer 204; and the sixth portion 1118-6 of the second III-nitride barrier layer 1118 and the second portion 204-2 of the second III-nitride access region layer 204.

As will be discussed further below, the provision of the first and the second AIN layers may be beneficial during fabrication of the III-nitride based bi-directional device 200.

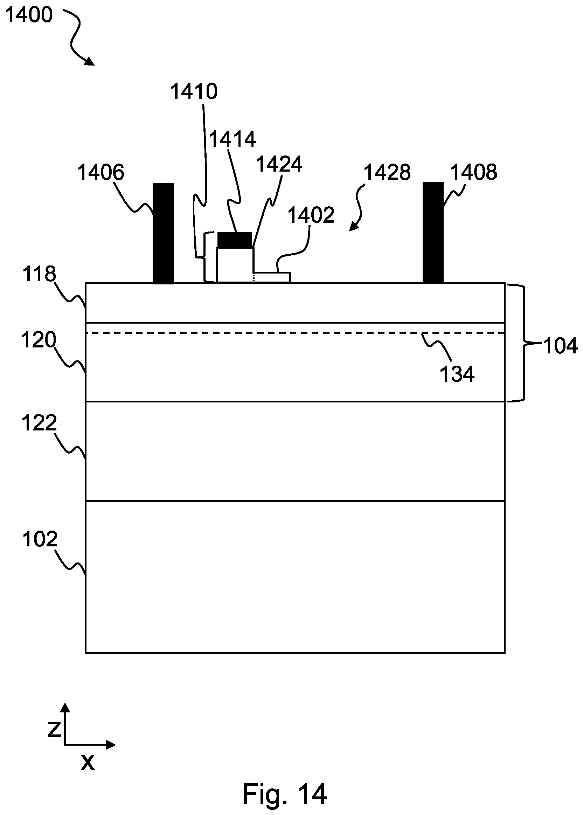

**Fig. 14** schematically illustrates a cross-sectional view of an example enhancement mode III-nitride based transistor 1400. The transistor 1400 may be a high electron mobility transistor (HEMT). The enhancement mode III-nitride based transistor 1400 has a number of elements in common with the various examples of the III-nitride based bi-directional device 200 discussed above in relation to Figs. 2 to 13. Such common elements may be denoted by common reference numerals and will not be described again in detail here, for the sake of brevity and clarity.

The enhancement mode III-nitride based transistor 1400 comprises: a source electrode 1406 and a drain electrode 1408 formed on the III-nitride heterostructure 104, the source electrode 1406 being formed over a source region and the drain electrode 1408 being formed over a drain region; an enhancement mode gate structure 1410 disposed laterally between the source electrode 1406 and the drain electrode 1408 and disposed over a transistor gate region of the III-nitride heterostructure 104; and a III-nitride access region layer 1402.

The source and the drain electrodes 1406, 1408 may comprise or consist of any suitable material, such as any suitable metal, metal alloy, or combination thereof. The source and the drain regions are laterally spaced apart in a first direction (e.g. the x direction depicted in Fig. 14). The source and the drain electrodes 1406, 1408 may be electrically coupled to the channel and therefore the 2DEG 134. For example, the source and the drain electrodes 1406, 1408 may form ohmic or Schottky contacts to the 2DEG 134.

The gate structure 1410 comprises a III-nitride layer 1424. The gate structure 1410 and the III-nitride layer 1424 may be similar to, and may comprise any one or more of the features of, the first gate structure 110 and the first III-nitride layer 124 of the III-nitride based bi-directional device 200 discussed herein in relation to Figs. 2 to 13, respectively.

The III-nitride access region layer 1402 may correspond to any of the first III-nitride access region layers 202 discussed above in relation to the various examples of the III-nitride based bi-directional device 200, with the exception that in the transistor 1400, it is disposed over a first portion of a drift region formed laterally between the transistor gate region and the drain region. The first portion of said drift region may extend from (e.g. directly) adjacent a drain-side edge of the transistor gate region in a direction towards the drain region. The III-nitride access region layer 1402 may be operatively coupled to the III-nitride heterostructure 104 in the first portion of said drift region.

The III-nitride access region layer 1402 of the transistor 1400 may give rise to the various benefits provided by the first III-nitride access region layer 202 in the III-nitride based bi-directional device 200 when operatively coupled to the low-voltage gate structure thereof. For example, in the transistor 1400, the III-nitride access region layer 1402 may reduce peak electric field intensities adjacent a drain-side edge of the gate structure 1410 when the transistor 1400 is an off-state and when a voltage difference is applied between the source and the drain electrodes 1406, 1408.

While the transistor 1400 is depicted in Fig. 14 as including the III-nitride heterostructure 104, it will be appreciated that this is merely for illustrative purposes and that the present disclosure is not so limited. In other examples, the transistor 1400 may comprise any variation of the heterostructure 104 discussed herein, such as the III-nitride heterostructure 704 or the III-nitride heterostructure 1104, for example.

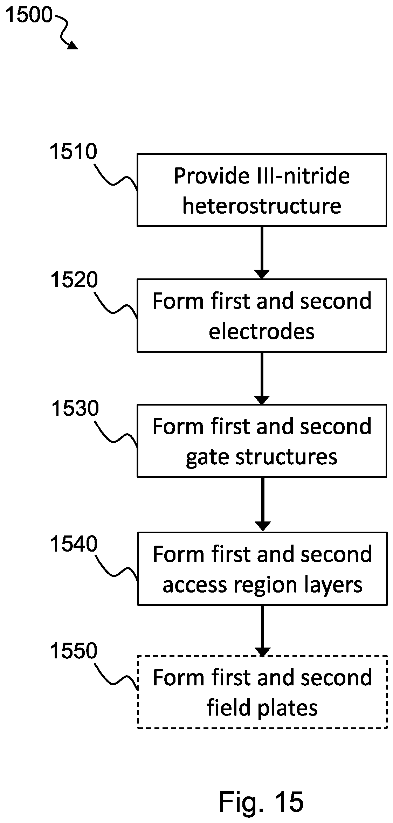

**Fig. 15** depicts a flow chart 1500 schematically illustrating a method of forming the III-nitride based bi-directional device 200.

At block 1510, the III-nitride heterostructure 104 is provided. The III-nitride heterostructure 104 may be disposed over the substrate 102. Additionally, the buffer layer 122 may be disposed between the substrate 102 and the III-nitride heterostructure 104. The III-nitride heterostructure 104 and the buffer layer 122 (when present) may have been formed over the substrate 102 by way of any suitable technique. For example, the III-nitride heterostructure 104 and the buffer layer 122 (when present) may have been grown on the substrate 102 by way of metal-organic chemical vapor deposition (MOCVD), molecular beam epitaxy (MBE), or any other suitable growth technique.

At block 1520, the first and the second conduction electrodes 106, 108 are formed on the respective first and second electrode regions of the III-nitride heterostructure 104. The first and the second conduction electrodes 106, 108 may be formed by way of any suitable process, such as any suitable micro- or nanofabrication process, such as conventional lithographic patterning and deposition processes.

At block 1530, the first and the second gate structures 110, 112 are formed over the respective first and second gate regions of the III-nitride heterostructure 104. The first and the second gate structures 110, 112 may be formed by way of any suitable process, such as any suitable micro- or nanofabrication process.

At block 1540, the first and the second III-nitride access region layers 202, 204 are formed. The first and the second III-nitride access region layers 202, 204 may be formed by way of any suitable process, such as any suitable micro- or nanofabrication process. For example, material of the first and the second III-nitride access region layers 202, 204 may be grown by way of plasma enhanced atomic layer deposition (PEALD), MBE, MOVCD, or any other suitable semiconductor growth technique.

Optionally, at block 1550, the first field plate 206 and the second field plate 208 are formed. The first and the second field plates 206, 208 may be formed by way of any suitable technique, such as any suitable micro- or nanofabrication technique.

While the flow chart 1500 illustrates the various blocks thereof to be performed in a particular order, it is to be understood that the present disclosure is not so limited and that the various operations discussed in relation to the blocks 1510 to 1550 may be performed in any suitable order. For example, the formation of the first and the second gate structures 110, 112 at block 1530 may be performed prior to the formation of the first and the second conduction electrodes 106, 108 at block 1520 (e.g. as part of a gate first process). One or more of the various operations discussed in relation to the blocks 1510 to 1550 may be performed contemporaneously. For example, at least part of the first and the second gate structures 110, 112 may be formed contemporaneously with the forming of the first and second III-nitride access region layers 202, 204.

**Fig. 16** depicts a flow chart 1600 schematically illustrating a method for forming the first and the second III-nitride layers 124, 126 of the first and the second gate structures 110, 112 and the first and the second III-nitride access region layers 202, 204 of the example III-nitride based bi-directional device 200, in accordance with various examples of the present disclosure. The method illustrated by the flow chart 1600 may correspond to examples of operations performed at blocks 1530 and 1540 of the flow chart 1500, for example.

Optionally, at block 1610, a first recess is formed in the (e.g. III-nitride barrier layer 118 of the) III-nitride heterostructure 104 in at least a portion of the first gate region and a second recess is formed in the (e.g. III-nitride barrier layer 118 of the) III-nitride heterostructure 104 in at least a portion of the second gate region. The first and the second recesses may be formed by way of any suitable technique, such as any suitable micro- or nanofabrication technique. For example, the first and the second recesses may be formed by way of conventional lithographic patterning, masking and etching techniques.

The first and the second recesses may extend partially through the III-nitride barrier layer 118. In such examples, the method depicted by the flow chart 1600 may be for forming the first and the second III-nitride layers 124, 126 and the first and the second III-nitride access region layers 202, 204 of the example III-nitride based bi-directional device 200 shown in Fig. 6.

Alternatively, the first and the second recesses may extend through an entire thickness of the III-nitride barrier layer 118 and may optionally extend into underlying portions of the III-nitride channel layer 120. In such examples, the method depicted by the flow chart 1600 may be for forming the first and the second III-nitride layers 124, 126 and the first and the second III-nitride access region layers 202, 204 of the example III-nitride based bi-directional device 200 shown in Fig. 7. In such examples, the III-nitride barrier layer 118 may be a first barrier layer, and block 1610 may additionally comprise (e.g. blanketly) forming the second III-nitride barrier layer 718 over remaining portions of the first III-nitride barrier layer 118 and in the first and the second recesses. The second III-nitride barrier layer 718 may be formed by way of any suitable technique. For example, the second IlI-nitride barrier layer 718 may be grown by way of plasma enhanced atomic layer deposition (PEALD), MBE, MOVCD, or any other suitable semiconductor growth technique. Accordingly, the second III-nitride barrier layer 718 may be a so-called "regrown" layer.

At block 1620, the first III-nitride layer 124 is formed over the first gate region, and the second III-nitride layer 126 is formed over the second gate region. The first and the second III-nitride layers 124, 126 may be formed by way of any suitable technique. For example, material of the first and the second III-nitride layers 124, 126 may be selectively grown in the first and the second gate regions. Alternatively, material of the first and the second III-nitride layers 124, 126 may be (e.g. blanketly) grown over the first and the second gate regions in addition to other regions, and selected portions of said material may be subsequently removed to thereby leave said material in the first and the second gate regions. The material of the first and the second III-nitride layers 124, 126 may be grown by way of any suitable technique, including but not limited to plasma enhance atomic layer deposition (PEALD), MBE, MOVCD, or by any other suitable growth technique.

At block 1630, subsequent to forming the first and the second III-nitride layers 124, 126, material of the first III-nitride access region layer 202 is grown over at least the first portion of the first access region 128, and material of the second III-nitride access region layer 204 is grown over at least the second portion of the first access region 128. In examples where the material of the first and the second III-nitride access region layers 202, 204 is the same, the growth of the material of the first and the second III-nitride access region layers 202, 204 may be performed contemporaneously. The material of the first and the second III-nitride access region layers 202, 204 may be grown by way of any suitable technique, including but not limited to plasma enhance atomic layer deposition (PEALD), MBE, MOVCD.

At block 1630, it may be that the growth of the material of the first and the second III-nitride access region layers 202, 204 in the respective first and second portions of the first access region 128 comprises the selective growth of said material in said regions.

For example, a patterned mask may be formed which exposes the first and the second portions of the first access region 128 and which shields other regions. The material of the first III-nitride access region layer 202 may then be selectively grown in the exposed first portion of the first access region 128 and the material of the second III-nitride access region layer 204 may be selectively grown in the exposed second portion of the first access region 128. In such examples, the patterned mask may at least partially expose an edge of the first III-nitride layer 124 such that the grown material of the first III-nitride access region layer 202 is contiguous with at least a portion of the first IlI-nitride layer 124. Similarly, the patterned mask may at least partially expose an edge of the second III-nitride layer 126 such that the grown material of the second III-nitride access region layer 204 is contiguous with at least a portion of the second III-nitride layer 126.

Alternatively, at block 1630, the material of the first III-nitride access region layer 202 may be (e.g. blanketly) grown over the first III-nitride layer 124 and the first portion of the access region 128. Similarly, the material of the second III-nitride access region layer 204 be (e.g. blanketly) grown over the second III-nitride layer 126 and the second portion of the access region 128. In such examples, at least a portion of the material of the first III-nitride access region layer 202 formed over the first III-nitride layer 124 may be selectively removed, for example by conventional lithographic patterning, masking and etching processes. This may be to expose a portion of the first III-nitride layer 124 for contacting the first gate electrode 114, for example. Similarly, at least a portion of the material of the second III-nitride access region layer 204 formed over the second III-nitride layer 126 may be selectively removed. This may be to expose a portion of the second III-nitride layer 126 for contacting the second gate electrode 116, for example.

Optionally, at block 1630, in examples where the second III-nitride barrier layer 718 is formed at block 1610, one or more portions of the second IlI-nitride barrier layer 718 may be selectively removed. Such portions may include a portion between the first and second portions of the first access region 128, for example. Such portion(s) of the second III-nitride barrier layer 718 may be selectively removed by conventional lithographic patterning, masking and etching techniques, for example. In such examples, the remaining portions of the second III-nitride barrier layer 718 may comprise, for example, the portions 718-1:718-4 discussed above in relation to Fig. 7, in addition to any one or more other portions of the second III-nitride barrier 718 discussed in relation to Fig. 7.

In the method depicted by the flow chart 1600, because the materials which form the first and the second III-nitride access region layers 202, 204 and the first and the second III-nitride layers 124, 126 are formed at separate steps, the respective thicknesses and/or doping concentrations of the first and the second III-nitride access region layers 202, 204 can be arbitrarily different from that of the first and the second III-nitride layers 124, 126. This in turn may enable the characteristics of each of these layers to be independently optimised for their respective functions.

**Fig.** 17 depicts a flow chart 1700 schematically illustrating a method for forming the first and the second III-nitride layers 124, 126 of the first and the second gate structures 110, 112 and the first and the second III-nitride access region layers 202, 204 of the example III-nitride based bi-directional device 200 depicted in Figs. 8 to 10. In these examples, the III-nitride based bi-directional device 200 comprises the third III-nitride layer 802 and the fourth III-nitride layer 804. The method illustrated by the flow chart 1700 may correspond to examples of operations performed at blocks 1530 and 1540 of the flow chart 1500, for example.

Optionally, at block 1710, a first recess is formed in the (e.g. III-nitride barrier layer 118 of the) III-nitride heterostructure 104 in at least a portion of the first gate region and a second recess is formed in the (e.g. III-nitride barrier layer 118 of the) III-nitride heterostructure 104 in at least a portion of the second gate region. The formation of these recesses may be in accordance with examples described at block 1610 of the flow chart 1600 and will not be described separately here.

The first and the second recesses may extend partially through the III-nitride barrier layer 118. In such examples, the method depicted in the flow chart 1700 may be for forming the first and the second III-nitride layers 124, 126 of the first and the second gate structures 110, 112 and the first and the second III-nitride access region layers 202, 204 of the example III-nitride based bi-directional device 200 depicted in Fig. 9.

Alternatively, the first and the second recesses may extend through an entire thickness of the III-nitride barrier layer 118 and may optionally extend into underlying portions of the III-nitride channel layer 120. In such examples, the method depicted in the flow chart 1700 may be for forming the first and the second III-nitride layers 124, 126 of the first and the second gate structures 110, 112 and the first and the second III-nitride access region layers 202, 204 of the example III-nitride based bi-directional device 200 depicted in Fig. 10. In such examples, the III-nitride barrier layer 118 may be a first III-nitride barrier layer, and block 1710 may additionally comprise forming the second III-nitride barrier layer 718. The formation of the second III-nitride barrier layer 718 may be in accordance with examples described in relation to block 1610 of the flow chart 1600 and will not be described separately here.

At block 1720, material of the first and the third III-nitride layers 124, 802 is formed over at least the first gate region and the first portion of the first access region 128, and material of the second and the fourth IlI-nitride layers 126, 804 is formed over at least the second gate region and the second portion of the first access region 128. It may be that the material of the first and third III-nitride layers 124, 802 is the same as the material of the second and fourth III-nitride layers 126, 804, respectively. In such examples, the material of the first and the second III-nitride layers 124, 126 may be formed contemporaneously. Additionally, the material of the third and the fourth III-nitride layers 802, 804 may be formed contemporaneously. The material of each of the first to fourth III-nitride layers 124, 126, 802, 804 may be formed by way of any suitable technique. For example, the material of each of the first to fourth Ill-nitride layers 124, 126, 802, 804 may be grown by way of plasma enhanced atomic layer deposition (PEALD), MBE, MOVCD, or by any other suitable growth technique.

Optionally, at block 1720, an etch stop layer is formed between the material of the first and the third III-nitride layers 124, 802 and between the material of the second and the fourth III-nitride layers 126, 804. The etch stop layer may comprise any suitable material that may provide for etch selectively relative to the material of the first and the second III-nitride layers 124, 126. For example, the material of the first and the second III-nitride layers 124, 126 may comprise or consist of GaN and the etch stop layer may comprise or consist of AlGaN (of any suitable molar composition).

At block 1730, material of the first III-nitride layer 124 over the first portion of the first access region 128 is selectively removed. Additionally, material of the second III-nitride layer 126 over the second portion of the first access region 128 is selectively removed. The material of the first and the second III-nitride layers 124, 126 may be selectively removed in said regions by way of any suitable process. For example, a patterned mask may be formed which exposes said regions and which shields other regions. An etch process, such as a wet etch process or a dry etch process may then be performed to etch the material of the first and the second III-nitride layers 124, 126 in the exposed regions. In examples wherein the etch stop layer formed, the etch stop layer may prevent the etch process from over etching into material underlying the first and the second III-nitride layers 124, 126. The remaining material of the third and the fourth III-nitride layers 802, 804 in the first and the second portions of the access region 128 may form the first and the second III-nitride access region layers 202, 204.

Optionally, at block 1730, in examples where the second III-nitride barrier layer 718 is formed at block 1710, one or more portions of the second IlI-nitride barrier layer 718 may be selectively removed. Such portions may include a portion between the first and second portions of the first access region 128, for example. Such portion(s) of the second III-nitride barrier layer 718 may be selectively removed by conventional lithographic patterning, masking and etching techniques, for example. In such examples, the remaining portions of the second III-nitride barrier layer may comprise, for example, the portions 718-1:718-4 discussed above in relation Fig. 7, in addition to any one or more other portions of the second III-nitride barrier 718 discussed in relation to Fig. 7.

As with the method depicted by the flow chart 1500, because the materials which form the first and the second III-nitride access region layers 202, 204 and the first and second III-nitride layers 124, 126 are formed at separate steps, the respective thicknesses and/or doping concentrations of the first and the second III-nitride access region layers 202, 204 can be arbitrarily different from those of the first and the second III-nitride layers 124, 126. This in turn may enable the characteristics of each of these layers to be independently optimised for their respective functions.

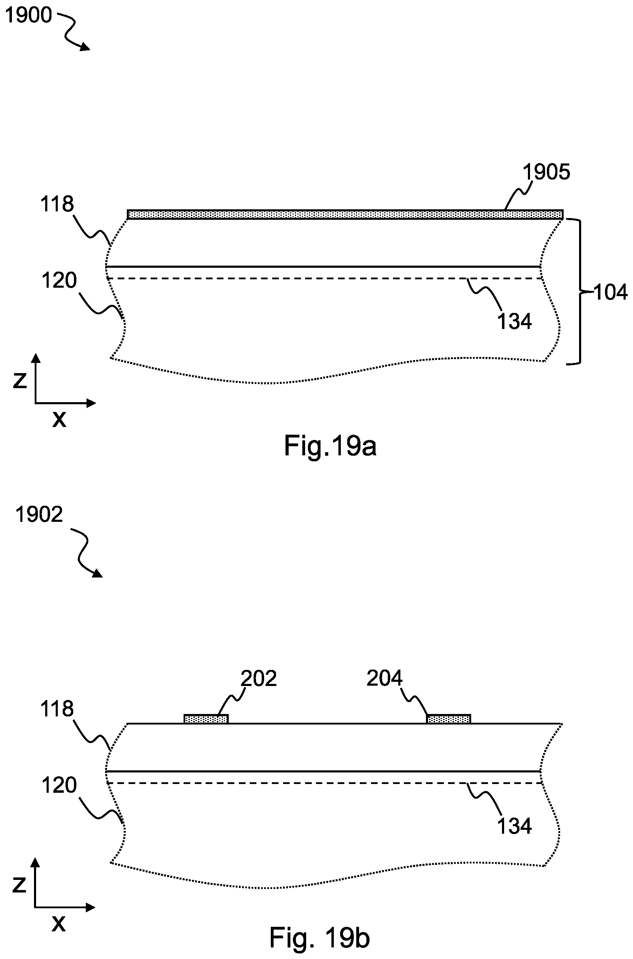

Fig. 18 depicts a flow chart 1800 schematically illustrating a method for forming the first and the second III-nitride layers 124, 126 of the first and the second gate structures 110, 112 and the first and the second III-nitride access region layers 202, 204 of the III-nitride based bi-direction device 200 depicted in Figs. 11 to 12. The method illustrated by the flow chart 1800 may correspond to examples of operations performed at blocks 1510, 1530 and 1540 of the flow chart 1500, for example. Figs. 19a-d schematically illustrate various starting or intermediate structures that may be obtained during performance of the method depicted by the flow chart 1800.

In the method depicted by the flow chart 1800, the first and the second III-nitride access region layers 202, 204 are formed from the same material. Additionally, the first and the second III-nitride layers 124, 126 are formed from the same material.

At block 1810, a starting structure 1900 is provided. Fig. 19a schematically illustrates an example cross-sectional view of a portion of the starting structure 1900. The starting structure 1900 may comprise the III-nitride heterostructure 104 and a III-nitride layer 1905 disposed thereover. Additionally, the starting structure 1900 may comprise the substrate 102 (not shown). In such examples, the III-nitride layer 1905 and the III-nitride heterostructure 104 may be disposed over the substrate 102. Additionally, the starting structure 1900 may comprise the buffer layer 122 (not shown) which may be disposed between the substrate 102 and the III-nitride heterostructure 104. While not depicted in Fig. 19a, the starting structure 1900 may additionally comprise an etch stop layer formed over the III-nitride layer 1905. The etch stop layer may be for controlling the etch process discussed below in relation to block in 1850. The III-nitride heterostructure 104 may comprise the III-nitride channel layer 120 and the (first) III-nitride barrier layer 118 disposed thereover. The III-nitride layer 1905 may comprise or consist of material of the first and the second III-nitride access region layers 202, 204.

The starting structure 1900 may have been formed by way of any suitable technique. For example, the III-nitride layer 1905, the III-nitride heterostructure 104, and the buffer layer 122 (when present) may have been grown on the substrate 102 by way of metal-organic chemical vapor deposition (MOCVD), molecular beam epitaxy (MBE), or any other suitable growth technique.

At block 1820, selected portions of the III-nitride layer 1905 are removed to thereby form the first and the second III-nitride access region layers 202, 204. The selected portions of the III-nitride layer 1905 may be removed by way of any suitable technique, such as by way of conventional lithographic patterning, masking and etching techniques. **Fig. 19b** schematically illustrates an example cross-sectional view of a portion of an intermediate structure 1902 that may be obtained following performance of block 1820.

At block 1830, the first and the second recesses described above in relation to Figs. 11 to 12 are formed in the first III-nitride barrier layer 118. The first and second recesses may be formed in the first III-nitride barrier layer 118 by way of any suitable technique, such as by way of conventional lithographic patterning, masking and etching techniques. In such examples, the first and the second recesses may be formed directly adjacent the first and second III-nitride access region layers 202, 204, respectively. Alternatively, there may be a first lateral distance separating the first III-nitride access region layer 202 and a nearest edge of the first recess, and a second lateral distance separating the second III-nitride access region layer 204 and a nearest edge of the second recess. Such lateral distances may be designed to accommodate alignment error that may occur during lithographic patterning and may be in accordance with examples disclosed herein.

Optionally, at block 1840, an AIN layer may be (e.g. blanketly) formed over remaining portions of the first III-nitride barrier layer 118, each of the first and second recesses, and the first and the second III-nitride access region layers 202, 204, such as by way of growing said AIN layer thereover, such as by way of plasma enhanced atomic layer deposition (PEALD), MBE, MOVCD, or any other suitable semiconductor growth technique.

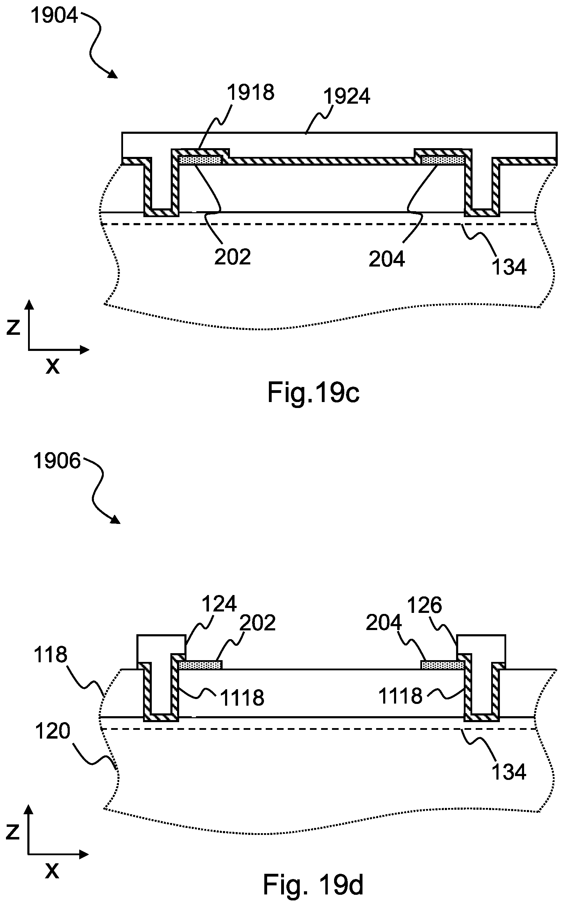

At block 1840, material 1918 of the second III-nitride barrier layer 1118 is (e.g. blanketly) formed over remaining portions of the first III-nitride barrier layer 118, each of the first and the second recesses, and the first and the second IIII-nitride access region 202, 204. The material 1918 of the second III-nitride barrier layer 1118 may be formed over the AIN layer, when present. Material 1924 of the first and the second III-nitride layers 124, 126 may then be (e.g. blanketly) formed over the material 1918 of the second III-nitride barrier layer 1118. **Fig.19c** schematically illustrates an example cross-sectional view of a portion of an intermediate structure 1904 that may be obtained following performance of block 1830. The material 1918 of the second III-nitride barrier layer 1118 and the material 1924 of the first and the second III-nitride layers 124, 126 may be formed by way of any suitable technique, such as by way of growing said material, such as by way of plasma enhanced atomic layer deposition (PEALD), MBE, MOVCD, or any other suitable growth technique.

At block 1850, selected portions of the material 1924 of the first and the second IlI-nitride layers 124, 126, of the material 1918 of the second III-nitride barrier layer 1218, and of the AIN layer (when present) are removed to thereby form the first and the second III-nitride layers 124, 126 of the first and the second gate structures 110, 12 and the second III-nitride barrier layer 1118 in accordance with the examples discussed in relation to Fig. 11. The selected portions of said material may be removed by way of any suitable technique, such as by way of conventional lithographic patterning, masking and etching techniques. In examples where an etch process is employed, and in examples where the AIN layer is formed at block 1840, said AIN layer may advantageously give rise to a clear endpoint detection signal indicating that the etch process has removed the AIN layer and reached the III-nitride access region layers 202, 204. Accordingly, the provision of the AIN layer may reduce the variability of the method depicted in the flow chart 1800. In examples where the starting structure includes the etch stop layer formed over the III-nitride layer 1905, the etch stop layer may be configured to provide for etch selectively relative to the material 1924 of the first and the second III-nitride layers 124, 126. For example, the material of the first and the second III-nitride layers 124, 126 may comprise or consist of GaN and the etch stop layer may comprise or consist of AlGaN (of any suitable molar composition). Accordingly, the provision of the etch stop layer may mitigate against over etching of the material 1924 into the first and the second access region layers 202, 204. Fig. 19d schematically illustrates an example cross-sectional view of a portion of an intermediate structure 1906 that may be obtained following performance of block 1850.

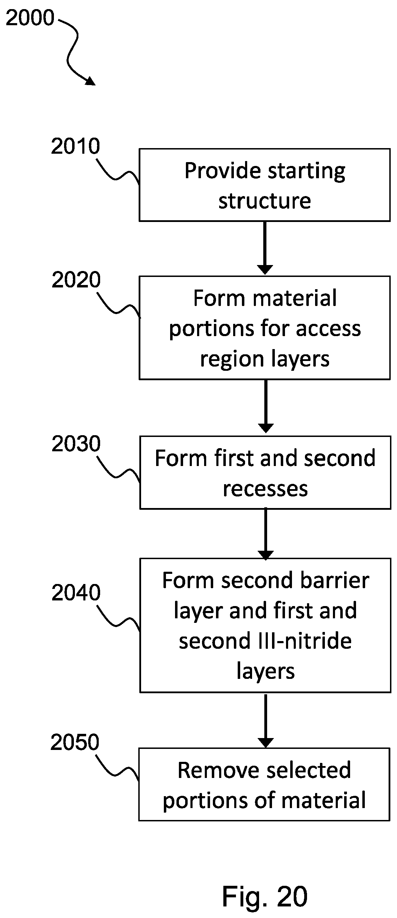

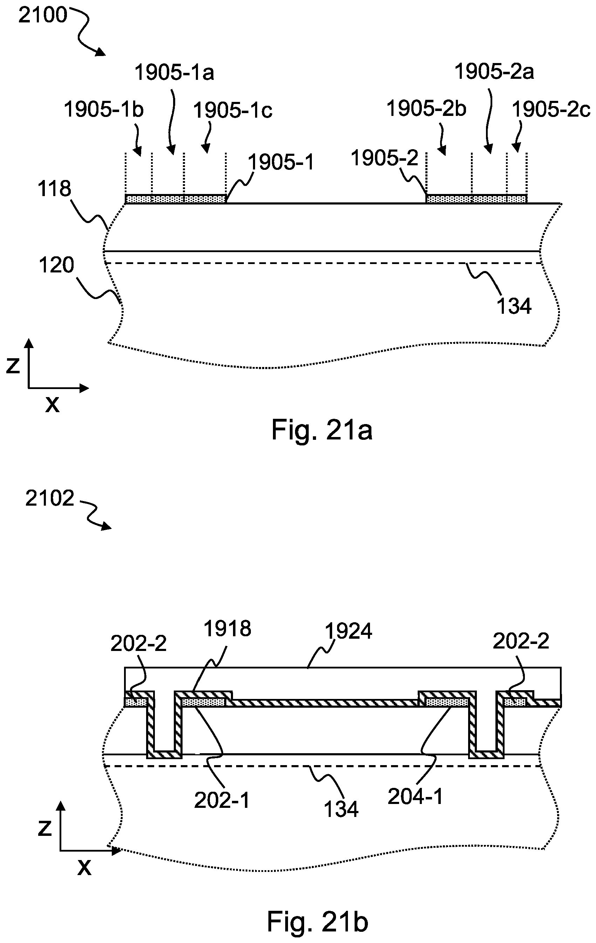

Fig. 20 depicts a flow chart 2000 schematically illustrating a method for forming the first and the second III-nitride layers 124, 126 of the first and the second gate structures 110, 112 and the first and the second III-nitride access region layers 202, 204 of the III-nitride based bi-directional device 200 depicted in Fig. 13. The method illustrated by the flow chart 2000 may correspond to examples of operations performed at blocks 1510, 1530 and 1540 of the flow chart 1500, for example. Figs. 21a-c schematically illustrate various intermediate structures that may be obtained during performance of the method depicted by the flow chart 2000.

In the method depicted by the flow chart 2000, the first and the second III-nitride access region layers 202, 204 are formed from the same material. Additionally, the first and the second III-nitride layers 124, 126 are formed from the same material.

At block 2010, a starting structure is provided. The starting structure is the same as the starting structure 1900 shown in Fig.19a and will not be described separately here.

At block 2020, selected portions of the III-nitride layer 1905 are removed to thereby form a first portion 1905-1 and a second portion 1905-2. The first portion 1905-1 may comprise a lateral inner portion 1905-1a, and lateral outer portions 1905-1b and c. The second portion 1905-2 may comprise a lateral inner portion 1905-2a, and lateral outer portions 1905-2b and c. The first portion 1905-1 may be for subsequently forming the first and the second portions 202-1, 202-2 of the first III-nitride access region layer 202 shown in Fig. 13. The second portion 1905-2 may be for subsequently forming the first and the second portions 204-1, 204-2 of the second III-nitride access region layer 204 shown in Fig. 13. The selected portions of the III-nitride layer 1905 may be removed by way of any suitable technique, such as by way of conventional lithographic patterning, masking and etching techniques. Fig. **21a** schematically illustrates an example cross-sectional view of a portion of an intermediate structure 2100 that may be obtained following performance of block 2020.

At block 2030, the first and the second recesses described above in relation to Fig. 13 are formed. The first and second recesses may be formed by way of any suitable technique, such as by way of conventional lithographic patterning, masking and etching techniques. For example, an etch mask may be formed which exposes the lateral inner portion 1905-1a of the first portion 1905-1 of the III-nitride layer 1905 and the lateral inner portion 1905-2a of the second portion 1905-2 of the III-nitride layer 1905. An etch process may then be employed to etch through the exposed lateral inner portions 1905-1a, 1905-2a of the III-nitride layer 1905 and through an entirety of underlying portions of the first III-nitride barrier layer 118. The remaining lateral outer portions 1905-1b and 1905-1c of the first portion 1905-1 of the III-nitride layer 1905 may form the first and the second portions 202-1, 202-2 of the first III-nitride access region layer 202, respectively. The remaining outer lateral portions 1905-2b and 1905-2c of the second portion 1905-2 of the III-nitride layer 1905 may form the first and the second portions 204-1, 204-2 of the second III-nitride access region layer 204, respectively. Accordingly, the first and the second portions 202-1, 202-2 of the first III-nitride access region layer 202 may be self-aligned to and directly adjacent respective edges of the first recess. Similarly, the first and the second portions 204-1, 204-2 of the second III-nitride access region layer 204 may be self-aligned to and directly adjacent respective edges of the second recess.

Optionally, at block 2030, an AIN layer may be (e.g. blanketly) formed over remaining portions of the first III-nitride barrier layer 118, each of the first and second recesses, the first and the second portions 202-1, 202-2 of the first III-nitride access region layer 202, and the first and the second portions 204-1, 204-2 of the second III-nitride access region layer 204. The AIN layer may be formed in accordance with examples described in relation to block 1840 of the flow chart 1800.

At block 2040, material 1918 of the second III-nitride barrier layer 1118 is (e.g. blanketly) formed over remaining portions of the first III-nitride barrier layer 118, each of the first and second recesses, the first and the second portions 202-1, 202-2 of the first III-Nitride access region layer 202, and the first and the second portions 204-1, 204-2 of the second III-nitride access region layer 204. The material 1918 of the second IlI-nitride barrier layer 1118 may be formed over the AIN layer, when present. Material 1924 of the first and the second III-nitride layers 124, 126 may then be formed over the material 1918 of the second III-nitride barrier layer 1118. **Fig. 21b** schematically illustrates an example cross-sectional view of a portion of an intermediate structure 2102 that may be obtained following performance of block 2040. The material of the second III-nitride barrier layer 118 and the material of the first and the second III-nitride layers 124, 126 may be formed in accordance with examples described in relation to the flow chart 1800.

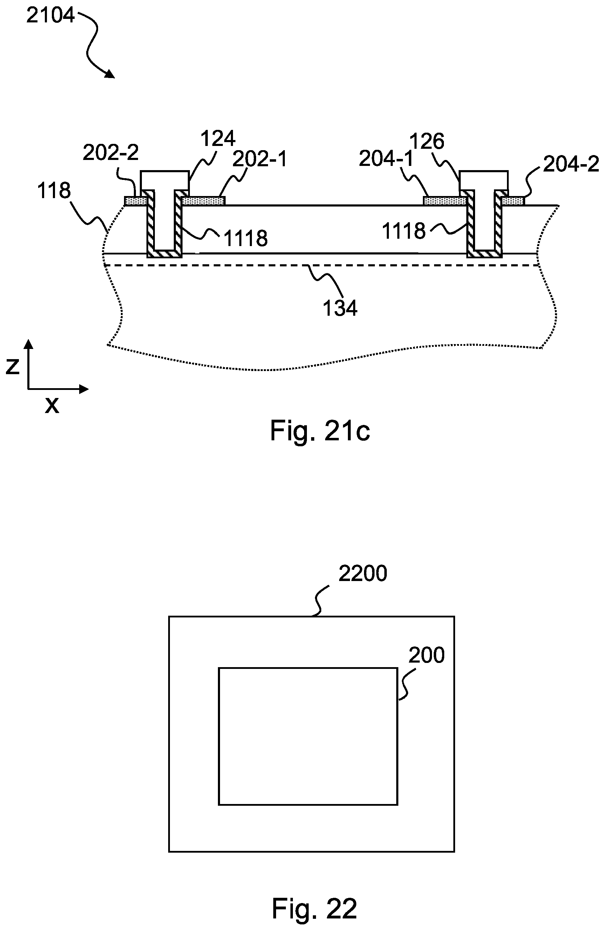

At block 2050, selected portions of the material 1924 of the first and the second IlI-nitride layers 124, 126, of the material 1918 of the second III-nitride barrier layer 1118, and of the AIN layer (when present) are removed to thereby form the first and the second III-nitride layers 124, 126 of the first and the second gate structures 110, 12 and the second III-nitride barrier layer 1118 in accordance with the examples discussed in relation to Fig. 13. The selected portions of said material may be removed by way of any suitable technique, such as by way of conventional lithographic patterning, masking and etching techniques. **Fig. 21c** schematically illustrates an example cross-sectional view of a portion of an intermediate structure 2104 that may be obtained following performance of block 2050.

**Fig. 22** schematically illustrates a semiconductor package 2200 comprising the III-nitride based bi-directional device 200 in accordance with any of the examples disclosed herein.

The examples described herein provide enhancement mode III-nitride based devices, such as enhancement mode III-nitride based bi-directional devices. Various devices of the present disclosure comprise III-nitride access region layer(s) which may serve to mitigate against damage to the devices resulting from peak electric fields generated in use. Any of the devices described herein may be provided in a semiconductor package.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

Throughout this specification the word "comprises", or variations such as "comprises" or "comprising", will be understood to imply the inclusion of a stated element, integer or step, or group of elements, integers or steps, but not the exclusion of any other element, integer or step, or group of elements, integers or steps.

The present disclosure also extends to the following numbered examples.

Example 1: A III-nitride based bi-directional device, comprising:
a III-nitride heterostructure configured to provide a channel of a first conductivity type;
first and second conduction electrodes formed on the III-nitride heterostructure and operatively coupled to the channel;
first and second enhancement mode gate structures disposed laterally between the first and the second conduction electrodes and disposed over respective first and second gate regions of the III-nitride heterostructure, wherein the first and the second enhancement mode gate structures comprise respective first and second gate electrodes;
a first III-nitride access region layer of a second conductivity type, wherein the first III-nitride access region layer is operatively coupled to the first gate structure, and wherein the first III-nitride access region layer is disposed over a first portion of an access region of the III-nitride heterostructure formed laterally between the first and the second gate regions, the first portion of the access region extending from an edge of the first gate region in a direction towards the second gate region; and
a second III-nitride access region layer of the second conductivity type, wherein the second III-nitride access region layer is operatively coupled to the second gate structure, and wherein the second III-nitride access region layer is disposed over a second portion of the access region, the second portion of the access region extending from an edge of the second gate region in a direction towards the first gate region.

Example 2: The III-nitride based bi-directional device of example 1, wherein each of the first and the second III-nitride access region layers comprises any one or more of: gallium nitride, aluminium gallium nitride; indium gallium nitride; indium aluminium nitride.

Example 3: The III-nitride based bi-directional device of example 1 or example 2, wherein the access region forms a drift region of the III-nitride based bi-directional device.

Example 4: The III-nitride based bi-directional device of any one of examples 1 to 3, wherein the first III-nitride access region layer is configured to cause at least partial depletion of charge carriers in (e.g. the channel in) the first portion of the access region when no external voltage is applied to the III-nitride based bi-directional device; and
wherein the second III-nitride access region layer is configured to cause at least partial depletion of charge carriers in (e.g. the channel in) the second portion of the access region when no external voltage is applied to the III-nitride based bi-directional device.

Example 5: The III-nitride based bi-directional device of any one of examples 1 to 4, wherein the first III-nitride access region layer is configured such that it is (e.g. substantially) fully depleted of charge carriers when the first gate structure is biased in an off state; and
wherein the second III-nitride access region layer is configured such that it is (e.g. substantially) fully depleted of charge carriers when the second gate structure is biased in an off state.

Example 6: The III-nitride based bi-directional device of any one of examples 1 to 5, wherein the first enhancement mode gate structure comprises a first III-nitride layer of the second conductivity type; and
wherein the second enhancement mode gate structure comprises a second III-nitride layer of the second conductivity type.

Example 7: The III-nitride based bi-directional device of example 6, wherein each of the first and the second III-nitride layers comprises or consists of gallium nitride.

Example 8: The III-nitride based bi-directional device of example 6 or example 7, wherein a (e.g. average) doping concentration of the first III-nitride layer is greater than a (e.g. average) doping concentration of the first III-nitride access region layer; and
wherein a (e.g. average) doping concentration of the second III-nitride layer is greater than a (e.g. average) doping concentration of the second III-nitride access region layer.

Example 9: The III-nitride based bi-directional device of any one of examples 6 to 8, wherein at least a portion of the first III-nitride layer is disposed within a first recess formed in the III-nitride heterostructure in the first gate region, and wherein at least a portion of the second III-nitride layer is disposed within a second recess formed in the III-nitride heterostructure in the second gate region.

Example 10: The III-nitride based bi-directional device of example 9, wherein each of the first and the second recesses are formed in a III-nitride barrier layer of the III-nitride heterostructure.

Example 11: The III-nitride based bi-directional device of example 10, wherein each of the first and the second recesses extend partially through the III-nitride barrier layer of the III-nitride heterostructure.

Example 12: The III-nitride based bi-directional device of example 10, wherein the III-nitride barrier layer is a first III-nitride barrier layer, wherein each of the first and the second recesses extend through an entire thickness of the first Ill-nitride barrier layer, and wherein the III-nitride heterostructure further comprises a second III-nitride barrier layer, the second Ill-nitride barrier layer comprising at least a first portion disposed in the first recess and a second portion disposed in the second recess.

Example 13: The III-nitride based bi-directional device of example 12, wherein the first portion of the second III-nitride barrier layer is disposed in the first recess between the first III-nitride layer and the channel; and
wherein the second portion of the second III-nitride barrier layer is disposed in the second recess between the second III-nitride layer and the channel.

Example 14: The III-nitride based bi-directional device of any one of examples 6 to 13, wherein a (e.g. average) thickness of the first III-nitride layer is greater than a (e.g. average) thickness of the first III-nitride access region layer, and wherein a (e.g. average) thickness of the second III-nitride layer is greater than a (e.g. average) thickness of the second III-nitride access region layer.

Example 15: The III-nitride based bi-directional device of any one of examples 6 to 14, wherein the first III-nitride access region layer is operatively coupled to at least a portion of the first III-nitride layer; and
wherein the second III-nitride access region layer is operatively coupled to at least a portion of the second IlI-nitride layer.

Example 16: The III-nitride based bi-directional device of example 15, further comprising:
a third III-nitride layer of the second conductivity type disposed between the first III-nitride layer and the III-nitride heterostructure, wherein the third III-nitride layer is continuous with the first III-nitride access region layer; and
a fourth III-nitride layer of the second conductivity type disposed between the second III-nitride layer and the III-nitride heterostructure, wherein the fourth III-nitride layer is continuous with the second III-nitride access region layer.

Example 17: The III-nitride based bi-directional device of example 16, wherein each of the third and the fourth III-nitride layers comprises any one or more of: gallium nitride; aluminium gallium nitride; indium gallium nitride; indium aluminium nitride.

Example 18: The III-nitride based bi-directional device of example 16 or example 17, wherein a (e.g. average) doping concentration of the third III-nitride layer is less than a (e.g. average) doping concentration of the first III-nitride layer; and
wherein a (e.g. average) doping concentration of the fourth III-nitride layer is less than a (e.g. average) doping concentration of the second III-nitride layer.

Example 19: The III-nitride based bi-directional device of example 18, wherein a (e.g. average) doping concentration of the first III-nitride access region layer is (e.g. substantially) the same as the (e.g. average) doping concentration of the third III-nitride layer; and
wherein an (e.g. average) doping concentration of the second III-nitride access region layer is (e.g. substantially) the same as the (e.g. average) doping concentration of the fourth III-nitride layer.

Example 20: The III-nitride based bi-directional device of any one of examples 16 to 19, wherein a (e.g. average) thickness of the third III-nitride layer is less than a (e.g. average) thickness of the first III-nitride layer; and
wherein a (e.g. average) thickness of the fourth III-nitride layer is less than a (e.g. average) thickness of the second III-nitride layer.

Example 21: The III-nitride based bi-directional device of example 20, wherein a (e.g. average) thickness of the first III-nitride access region layer is (e.g. substantially) the same as a (e.g. average) thickness of the third III-nitride layer; and
wherein a (e.g. average) thickness of the second III-nitride access region layer is (e.g. substantially) the same as a (e.g. average) thickness of the fourth III-nitride layer.

Example 22: The III-nitride based bi-directional device of any one of examples 6 to 21, wherein the first gate electrode of the first gate structure forms a first Schottky contact with the first III-nitride layer; and
wherein the second gate electrode of the second gate structure forms a second Schottky contact with the second Ill-nitride layer.

Example 23: The III-nitride based bi-directional device of any one of examples 6 to 21, wherein the first gate electrode of the first gate structure forms a first ohmic contact with the first III-nitride layer; and
wherein the second gate electrode of the second gate structure forms a second ohmic contact with the second III-nitride layer.

Example 24: The III-nitride based bi-directional device of any one of examples 1 to 23, further comprising:
a first field plate electrically coupled to the first electrode (e.g. and extending from the first electrode over at least a portion of the first III-nitride access region layer); and
a second field plate electrically coupled to the second electrode (e.g. and extending from the second electrode over at least a portion of the second III-nitride access region layer).

Example 25: The III-nitride based bi-directional device of any one of examples 1 to 24, wherein the first conductivity type is n-type and the second conductivity type is p-type.

Example 26: A semiconductor package comprising the bi-directional device of any one of examples 1 to 25.

Example 27: A method of forming a III-nitride based bi-directional device, the method comprising:
providing a III-nitride heterostructure comprising a heterojunction configured to provide a channel of a first conductivity type;
forming first and second conduction electrodes on respective first and second electrode regions of the III-nitride heterostructure, the first and the second conduction electrodes being operatively coupled to the channel;
forming first and second enhancement mode gate structures over respective first and second gate regions of the III-nitride heterostructure, the first and the second enhancement mode gate structures comprising respective first and second gate electrodes, the first and the second gate regions being positioned laterally between the first and the second electrode regions; and
forming first and second III-nitride access region layers over respective first and second portions of an access region of the III-nitride heterostructure formed laterally between the first and the second gate regions;
wherein the first portion of the access region extends from an edge of the first gate region in a direction towards the second gate region;
wherein the second portion of the access region extends from an edge of the second gate region in a direction towards the first gate region; and
wherein the first and the second III-nitride access region layers are of a second conductivity type and are operatively coupled to the respective first and the second gate structures.

Example 28: The method of example 27, wherein each of the first and the second III-nitride access region layers comprises any one or more of: gallium nitride; aluminium gallium nitride; indium gallium nitride; indium aluminium nitride.

Example 29: The method of example 27 or example 28, wherein the access region forms part of a drift region of the III-nitride based bi-directional device.

Example 30: The method of any one of examples 27 to 29, wherein the first III-nitride access region layer is configured to cause at least partial depletion of charge carriers in (e.g. the channel in) the first portion of the access region when no external voltage is applied to the III-nitride based bi-directional device; and
wherein the second III-nitride access region layer is configured to cause at least partial depletion of charge carriers in (e.g. the channel in) the second portion of the access region when no external voltage is applied to the III-nitride based bi-directional device.

Example 31: The method of any one of examples 27 to 30, wherein the first III-nitride access region layer is configured such that it is (e.g. substantially) fully depleted of charge carriers when the first gate structure is biased in an off state; and
wherein the second III-nitride access region layer is configured such that it is (e.g. substantially) fully depleted of charge carriers when the second gate structure is biased in an off state.

Example 32: The method of any one of examples 27 to 31, wherein the first enhancement mode gate structure comprises a first III-nitride layer of the second conductivity type; and
wherein the second enhancement mode gate structure comprises a second III-nitride layer of the second conductivity type.

Example 33: The method of example 32, wherein each of the first and the second III-nitride layers comprises gallium nitride.

Example 34: The method of example 32 or example 33, wherein a (e.g. average) doping concentration of the first III-nitride layer is greater than a (e.g. average) doping concentration of the first III-nitride access region layer; and
wherein a (e.g. average) doping concentration of the second III-nitride layer is greater than a (e.g. average) doping concentration of the second III-nitride access region layer.

Example 35: The method of any one of examples 32 to 34, wherein at least a portion of the first III-nitride layer is disposed within a first recess formed in the III-nitride heterostructure in the first gate region, and wherein at least a portion of the second III-nitride layer is disposed within a second recess formed in the III-nitride heterostructure in the second gate region.

Example 36: The method of example 35, wherein each of the first and the second recess are formed in a III-nitride barrier layer of the III-nitride heterostructure.

Example 37: The method of example 36, wherein each of the first and the second recesses extend partially through the III-nitride barrier layer of the III-nitride heterostructure.

Example 38: The method of example 36, wherein the III-nitride barrier layer is a first III-nitride barrier layer, wherein each of the first and the second recesses extend through an entire thickness of the first III-nitride barrier layer, and wherein the III-nitride heterostructure further comprises a second III-nitride barrier layer, the second III-nitride barrier layer comprising at least a first portion disposed in the first recess and a second portion disposed in the second recess.

Example 39: The method of example 38, wherein the first portion of the second III-nitride barrier layer is disposed in the first recess between the first III-nitride layer and the channel; and
wherein the second portion of the second III-nitride barrier layer is disposed in the second recess between the second III-nitride layer and the channel.

Example 40: The method of any one of examples 32 to 39, wherein a (e.g. average) thickness of the first III-nitride layer is greater than a (e.g. average) thickness of the first III-nitride access region layer, and wherein a (e.g. average) thickness of the second III-nitride layer is greater than a (e.g. average) thickness of the second III-nitride access region layer.

Example 41: The method of any one of examples 32 to 40, wherein the first III-nitride access region layer is operatively coupled to at least a portion of the first III-nitride layer; and
wherein the second III-nitride access region layer is operatively coupled to at least a portion of the second IlI-nitride layer.

Example 42: The method of example 41, wherein a third III-nitride layer of the second conductivity type is disposed between the first III-nitride layer and the III-nitride heterostructure, wherein the third III-nitride layer is continuous with the first access region layer; and
wherein a fourth III-nitride layer of the second conductivity type is disposed between the second III-nitride layer and the III-nitride heterostructure, wherein the fourth III-nitride layer is continuous with the second III-nitride access region layer.

Example 43: The method of example 42, wherein each of the third and the fourth III-nitride layers comprises any one or more of: gallium nitride; aluminium gallium nitride; indium gallium nitride; indium aluminium nitride.

Example 44: The method of example 42 or example 43, wherein a (e.g. average) doping concentration of the third III-nitride layer is less than a (e.g. average) doping concentration of the first III-nitride layer; and
wherein a (e.g. average) doping concentration of the fourth III-nitride layer is less than a (e.g. average) doping concentration of the second III-nitride layer.

Example 45: The method of example 44, wherein a (e.g. average) doping concentration of the first III-nitride access region layer is (e.g. substantially) the same as the (e.g. average) doping concentration of the third III-nitride layer; and
wherein an (e.g. average) doping concentration of the second III-nitride access region layer is (e.g. substantially) the same as the (e.g. average) doping concentration of the fourth III-nitride layer.

Example 46: The method of any one of examples 42 to 45, wherein a (e.g. average) thickness of the third III-nitride layer is less than a (e.g. average) thickness of the first III-nitride layer; and
wherein a (e.g. average) thickness of the fourth III-nitride layer is less than a (e.g. average) thickness of the second III-nitride layer.

Example 47: The method of example 46, wherein a (e.g. average) thickness of the first III-nitride access region layer is (e.g. substantially) the same as a (e.g. average) thickness of the third III-nitride layer; and
wherein a (e.g. average) thickness of the second III-nitride access region layer is (e.g. substantially) the same as a (e.g. average) thickness of the fourth III-nitride layer.

Example 48: The method of any one of examples 32 to 47, wherein the first gate electrode of the first gate structure forms a first Schottky contact with the first IlI-nitride layer; and
wherein the second gate electrode of the second gate structure forms a second Schottky contact with the second Ill-nitride layer.

Example 49: The method of any one of examples 32 to 47, wherein the first gate electrode of the first gate structure forms a first ohmic contact with the first Ill-nitride layer; and
wherein the second gate electrode of the second gate structure forms a second ohmic contact with the second III-nitride layer.

Example 50: The method of any one of examples 27 to 49, further comprising:
forming a first field plate, the first field plate being electrically coupled to the first electrode (e.g. and extending from the first electrode over at least a portion of the first III-nitride access region layer); and
forming a second field plate, the second field plate being electrically coupled to the second electrode (e.g. and extending from the second electrode over at least a portion of the second III-nitride access region layer).

Example 51: The method of any one of examples 27 to 50, wherein the first conductivity type is n-type and the second conductivity type is p-type.

Example 52: The method of any one of examples 41 to 51, wherein the forming the first enhancement mode gate structure and the forming the first III-nitride access region layer comprises:
forming, over each of the first gate region and the first portion of the access region, material of the first and the third III-nitride layers, the material of the first III-nitride layer being disposed over the material of the third III-nitride layer; and
selectively removing the material of the first III-nitride layer over the first portion of the access region;
   and
wherein the forming the second enhancement mode gate structure and the forming the second III-nitride access region layer comprises:
   forming, over each of the second gate region and the second portion of the access region, material of the second and the fourth III-nitride layers, the material of the second III-nitride layer being disposed over the material of the fourth IlI-nitride layer; and
   selectively removing the material of the second IlI-nitride layer over the second portion of the access region.

Example 53: The method of example 52, wherein the forming the material of the first and the third III-nitride layers over each of the first gate region and the first portion of the access region further comprises forming a first etch stop layer between the material of the first and the third III-nitride layers;
wherein the forming the material of the second and the fourth III-nitride layers over each of the second gate region and the second portion of the access region further comprises forming a second etch stop layer between the material of the second and the fourth III-nitride layers; and
wherein the selectively removing the material of the first and the fourth III-nitride layers over the respective first and the second portions of the access region comprises selectively etching the material of the first and the fourth IlI-nitride layers over the respective first and the second portions of the access region.

Example 54: The method of any one of examples 41 to 51, further comprising:
forming the first III-nitride layer over the first gate region; and
subsequent to forming the first III-nitride layer over the first gate region, growing material of the first III-nitride access region layer over at least the first portion of the access region;
   and
forming the second III-nitride layer over the second gate region; and
subsequent to forming the second III-nitride layer over the second gate region, growing material of the second III-nitride access region layer over at least the second portion of the access region.

Example 55: The method of example 54, wherein the growing the material of the first III-nitride access region layer over at least the first portion of the access region comprises selectively growing said material over at least the first portion of the access region such that said material is contiguous with at least a portion of the first III-nitride layer; and
wherein the growing the material of the second III-nitride access region layer over at least the second portion of the access region comprises selectively growing said material over at least the second portion of the access region such that said material is contiguous with at least a portion of the second III-nitride layer.

Example 56: The method of example 55, wherein the growing the material of the first III-nitride access region layer over at least the first portion of the access region comprises growing said material over each of the first portion of the access region and the first III-nitride layer; and
wherein the growing the material of the second III-nitride access region layer over at least the second portion of the access region comprises growing said material over each of the second portion of the access region and the second III-nitride layer.

Example 57: The method of example 56, further comprising:
selectively removing at least a portion of the material of the first III-nitride access region layer over the first III-nitride layer; and
selectively removing at least a portion of the material of the second III-nitride access region layer over the second Ill-nitride layer.

Example 58: The III-nitride based bi-directional device or the method of any one preceding example, wherein the first III-nitride access region layer is configured to cause at least partial depletion of charge carriers of the second conductivity type in the first III-nitride access region layer itself when the first gate structure operates as a low-voltage gate in an off-state (e.g. thereby leading to a depletable field-plate effect); and
wherein the second III-nitride access region layer is configured to cause at least partial depletion of charge carriers of the second conductivity type in the second III-nitride access region layer itself when the second gate structure operates as a low-voltage gate in an off-state (e.g. thereby leading to a depletable field-plate effect).

## Claims

1. A III-nitride based bi-directional device, comprising:
a III-nitride heterostructure configured to provide a channel of a first conductivity type;
first and second conduction electrodes formed on the III-nitride heterostructure and operatively coupled to the channel;
first and second enhancement mode gate structures disposed laterally between the first and the second conduction electrodes and disposed over respective first and second gate regions of the III-nitride heterostructure, wherein the first and the second enhancement mode gate structures comprise respective first and second gate electrodes;
a first III-nitride access region layer of a second conductivity type, wherein the first III-nitride access region layer is operatively coupled to the first gate structure, and wherein the first III-nitride access region layer is disposed over a first portion of an access region of the III-nitride heterostructure formed laterally between the first and the second gate regions, the first portion of the access region extending from an edge of the first gate region in a direction towards the second gate region; and
a second III-nitride access region layer of the second conductivity type, wherein the second III-nitride access region layer is operatively coupled to the second gate structure, and wherein the second III-nitride access region layer is disposed over a second portion of the access region, the second portion of the access region extending from an edge of the second gate region in a direction towards the first gate region.

2. The III-nitride based bi-directional device of claim 1, wherein each of the first and the second III-nitride access region layers comprises any one or more of: gallium nitride; aluminium gallium nitride; indium gallium nitride; indium aluminium nitride.

3. The III-nitride based bi-directional device of claim 1 or claim 2, wherein the access region forms a drift region of the III-nitride based bi-directional device.

4. The III-nitride based bi-directional device of any one of claims 1 to 3,
wherein the first III-nitride access region layer is configured to cause at least partial depletion of charge carriers in the first portion of the access region when no external voltage is applied to the III-nitride based bi-directional device; and
wherein the second III-nitride access region layer is configured to cause at least partial depletion of charge carriers in the second portion of the access region when no external voltage is applied to the III-nitride based bi-directional device;
and/or
wherein the first III-nitride access region layer is configured to cause at least partial depletion of charge carriers of the second conductivity type in the first III-nitride access region layer itself when the first gate structure operates as a low-voltage gate in an off-state, thereby leading to a depletable field-plate effect; and
wherein the second III-nitride access region layer is configured to cause at least partial depletion of charge carriers of the second conductivity type in the second III-nitride access region layer itself when the second gate structure operates as a low-voltage gate in an off-state, thereby leading to a depletable field-plate effect.

5. The III-nitride based bi-directional device of any one of claims 1 to 4, wherein the first enhancement mode gate structure comprises a first III-nitride layer of the second conductivity type; and
wherein the second enhancement mode gate structure comprises a second III-nitride layer of the second conductivity type.

6. The III-nitride based bi-directional device of claim 5, wherein each of the first and the second III-nitride layers comprises gallium nitride.

7. The III-nitride based bi-directional device of claim 5 or claim 6, wherein a doping concentration of the first III-nitride layer is greater than a doping concentration of the first III-nitride access region layer; and
wherein a doping concentration of the second III-nitride layer is greater than a doping concentration of the second III-nitride access region layer.

8. The III-nitride based bi-directional device of any one of claims 5 to 7, wherein at least a portion of the first III-nitride layer is disposed within a first recess formed in the III-nitride heterostructure in the first gate region, and wherein at least a portion of the second III-nitride layer is disposed within a second recess formed in the III-nitride heterostructure in the second gate region.

9. The III-nitride based bi-directional device of any one of claims 5 to 8, wherein a thickness of the first III-nitride layer is greater than a thickness of the first III-nitride access region layer, and wherein a thickness of the second III-nitride layer is greater than a thickness of the second III-nitride access region layer.

10. The III-nitride based bi-directional device of any one of claims 5 to 9, wherein the first gate electrode of the first gate structure forms a first Schottky contact with the first IlI-nitride layer; and
wherein the second gate electrode of the second gate structure forms a second Schottky contact with the second Ill-nitride layer.

11. The III-nitride based bi-directional device of any one of claims 5 to 9, wherein the first gate electrode of the first gate structure forms a first ohmic contact with the first III-nitride layer; and
wherein the second gate electrode of the second gate structure forms a second ohmic contact with the second III-nitride layer.

12. The III-nitride based bi-directional device of any one of claims 1 to 11, further comprising:
a first field plate operatively coupled to the first conduction electrode; and
a second field plate operatively coupled to the second conduction electrode.

13. The III-nitride based bi-directional device of any one of claims 1 to 12, wherein the first conductivity type is n-type and the second conductivity type is p-type.

14. A semiconductor package comprising the III-nitride based bi-directional device of any one of claims 1 to 13.

15. A method of forming a III-nitride based bi-directional device, the method comprising:
providing a III-nitride heterostructure comprising a heterojunction configured to provide a channel of a first conductivity type;
forming first and second conduction electrodes on respective first and second electrode regions of the III-nitride heterostructure, the first and the second conduction electrodes being operatively coupled to the channel;
forming first and second enhancement mode gate structures over respective first and second gate regions of the III-nitride heterostructure, the first and the second enhancement mode gate structures comprising respective first and second gate electrodes, the first and the second gate regions being positioned laterally between the first and the second electrode regions; and
forming first and second III-nitride access region layers over respective first and second portions of an access region of the III-nitride heterostructure formed laterally between the first and the second gate regions;
wherein the first portion of the access region extends from an edge of the first gate region in a direction towards the second gate region;
wherein the second portion of the access region extends from an edge of the second gate region in a direction towards the first gate region; and
wherein the first and the second III-nitride access region layers are of a second conductivity type and are operatively coupled to the respective first and the second gate structures.
